# EUROPEAN PATENT SPECIFICATION

(11) **EP 1 040 210 B1**
(45) Date of publication and mention of the grant of the patent: **12.05.2004**
(21) Application number: 98959227.4
(22) Date of filing: 21.11.1998
(51) Int. Cl.: C23C 16/44

(54) **PLASMA POLYMERIZATION ON SURFACE OF MATERIAL**
PLASMAPOLYMERISATION AUF OBERFLÄCHEN VON MATERIALIEN
POLYMERISATION PAR PLASMA SUR UNE SURFACE DE MATIERE

(30) Priority: 21.11.1997 KR 6176797
(43) Date of publication of application: 04.10.2000
(60) Divisional application: 03004001.8
(73) Proprietor: KOREA INSTITUTE OF SCIENCE AND TECHNOLOGY, Seoul 136-791 (KR)
(72) Inventor: KOH, Seok-Keun,, Dongdaemoon-ku Seoul 130-011 (KR); JUNG, Hyung, Jin,, Dongdaemoon-ku Seoul 130-010 (KR); CHOI, Won, Kook,, Yangcheon-ku Seoul 158-055 (KR); KIM, Ki Hwan,, Nowon-ku Seoul 139-051 (KR); HA, Sam Chul,, Kyungsangnam-do 641-041 (KR); KIM, Cheol Hwan, Kaenari 2-cha Apt. 204-905, Kyungsangnam-do 641-100 (KR); CHOI, Sung-Chang,, Yongdungpo-ku Seoul 150-102 (KR)
(74) Representative: Ghioni, Carlo Raoul Maria
(86) International application number: PCT/KR1998/000372
(87) International publication number: WO 1999/027156

(56) References cited:
- WO-A1-93/10283
- US-A- 4 598 022
- US-A- 4 693 799
- US-A- 4 988 573
- US-A- 5 549 935

## Description

### TECHNICAL FIELD

The present invention relates to a plasma polymerization and a polymer, and in particular to a plasma polymerization for forming a polymer with hydrophilicity or hydrophobicity on a surface of a material by using DC discharge or RF discharge, and to the polymer formed by the plasma polymerization.

### BACKGROUND ART

Efforts have been made to satisfy various demands by forming a functional surface on a material. Among methods known for forming the functional surface are: (1) depositing the functional layer on the surface of the material; and (2) modifying a surface of the material in order to have new physical and chemical properties.

A method for modifying a surface property of a polymer material to hydrophilicity by using an ion beam and a reaction gas has been disclosed by the inventors of the present invention in USP No. 5,783,641. According to this method which is called "Ion Beam Assisted Reaction", the surface of a polymer material is activated by irradiating energetic argon ions and oxygen ions thereon, and at the same time the surface property of the polymer is modified to hydrophilicity by providing the reactive gas around the polymer and forming hydrophilic functional groups on the surface thereof. In this case, according to "Surface Chemical Reaction between Polycarbonate (PC) and keV Energy Ar⁺ Ion in Oxygen Environment" (J. Vac. Sci. Tech., 14, 359, 1996) which has been disclosed by the inventors of the present invention, the hydrophilic functional groups, such as C-O, C=O, (C=O)-O, etc., are formed on the surface of the polymer. Many polymers, such as PC, PMMA, PET, PE, PI, and silicone rubber can be modified to have a hydrophilic surface by the ion assisted reaction.

In addition, in accordance with "The Improvement of Mechanical Properties of Aluminum Nitride and Alumina By 1 keV Ar⁺ Irradiation in Reactive Gas Environment" ["Ion-Solid Interactions For Materials Modification And Processing", Mat. Soc. Symp. Proc.396, 261 (1996)] which has been disclosed by the inventors of the present invention, the surface modification by the ion beam assisted reaction is not a method which can be used merely for polymer materials. That is, the surface modification can be also performed on a ceramic material by the ion beam assisted reaction. The characteristics of the ceramic material, such as the mechanical strength thereof can be improved by forming a new functional layer on the surface thereof.

Also, the ion beam assisted reaction can be employed for a metal. When aluminum is processed by the ion beam assisted reaction, the hydrophilicity of the aluminum metal surface is increased. However, the value of the wetting angle with water is varied according to the lapse of time on a surface of a process sample which is measured to examine hydrophilicity. That is, the value of the wetting angle is increased with the lapse of time, and restored to an original value after the lapse of a certain amount of time.

When a metal such as aluminum is processed by the ion beam assisted reaction, hydrophilicity is increased because a native oxide layer is removed by etching carried out on the aluminum surface and a functional layer is formed thereon. That is, the effect of improvement in hydrophilicity is reduced with the lapse of time because the native oxide layer is naturally grown on the aluminum surface, and the aluminum surface is restored to its original state because the functional layer which consists of a thin layer (less than several nm) has little mechanical resistance against environmental changes (water, temperature, etc.) with the lapse of time.

Accordingly, forming a hydrophilic layer on the surface of the metal by the ion beam assisted reaction which has been utilized for the polymer and ceramic material is ineffective due to the above-described disadvantage.

This disadvantage in modifying the metal material to have hydrophilicity occurs because the hydrophilic layer is not stable. Thus, a hydrophilic layer which is physically and chemically stable should be formed in order to overcome such a disadvantage. A hydrophilic layer which is stable on the metal surface can be formed by depositing a hydrophilic polymer.

In order to deposit a polymer on a material by the conventional deposition technique, at least several process steps are required: (1) synthesizing a monomer; (2) performing a polymerization so as to form a polymer or an intermediate polymer for a next succeeding step; (3) producing a coating solution; (4) cleansing and/or conditioning of a substrate surface by application of primer or coupling agent; (5) coating; (6) drying a coated layer; and (7) curing the coated layer.

The above-described process can be replaced by a one-step process according to a plasma polymerization for carrying out a polymerization by introducting a gaseous material to be polymerized into a vacuum chamber under a relatively low vacuum state (1,33-133,33 Pa), forming the gas plasma by, using DC power or RF power and simultaneously generating a reaction of various ionized gases, radicals and the like which are formed inside the plasma under the applied energy. A polymer formed according to the plasma polymerization has strong adhesion to the substrate and high chemical resistance.

For example, the plasma polymerization may be performed on the metal surface according to the technique disclosed in USP No. 4,980,196. A low-temperature plasma process is employed so as to prevent corrosion of a steel, the process including the steps of: (1) pretreating the steel substrate by a reactive or inert gas plasma; (2) using DC power from 100-2000 volts, preferably 300-1200 volts for the plasma deposition; (3) making the steel substrate the cathode; (4) having anode(s) equipped with magnetic enhancement (i.e. magnetron); and (5) using organosilane vapors (with or without nonpolymerizable gas) as the plasma gas to be deposited. That is, in accordance with USP No. 4,980,196, the cathode is used as the substrate, and a magnetron is installed on the anode. The plasma is formed on the steel substrate by using the organosilane vapors and DC power. The plasma polymerization is then carried out. In addition, the above-described patent further discloses performing a primer coating after the plasma polymerization.

However, a magnetron must be installed at the anode side to perform the above-described process, and thus the device is more complicated. There is another disadvantage to the process in that the degree of hydrophilicity or hydrophobicity cannot be controlled.

From US4693799 it is known a process for producing a plasma polymerized film, which comprises forming a plasma polymerized film on the surface of a substrate placed in a reaction zone by subjecting an organic compound containing gas to plasma polymerization utilizing low temperature plasma formed by pulse discharging, in which the time for non-discharge condition is at least 1 msec. and the voltage rise time for gas breakdown is not longer than 100 msec. The plasma polymerized film obtained has a small coefficient of friction, high lubricity, durability and heat resistance and is useful as a solid lubricating film, etc.

From WO9310283 it is known a methode to produce a steel sheet electroplated with an Al-Zn alloy to have excellent phosphatability and corrosion resistance. The sheet is first surface treated by plasma deposition of a thin polymeric film and thaen it is immersed in a molten salt bath and a molten salt electrolysis is conducetd by using the sheet as a cathode.

It is also known from document US5549935 a method for adhering a polymeric fluorocarbon film to a substrate. The method comprises the steps of: providing a thin layer of silicon or a silicide on the substrate; placing the substrate and a working electrode in a chamber having walls, wherein the chamber can be evacuated and wherein the walls of the chamber and the electrode are coated with a polymeric fluorocarbon coating and wherein the electrode is capacitively coupled; introducing in the chamber a gaseous polymerizable fluorocarbon; applying radiofrequency to said electrode, to thereby deposit a polymeric fluorocarbon film on the layer of silicon or silicide and whereby the thin layer is intermediate the substrate and the polymeric fluorocarbon film.

Document US4988573 discloses a recording and/or reproducing medium related member which constructs or is disposed in a casing in which a tape or disk-shaped medium is received for travel or rotating motion and is in sliding contact with the tape or disk-shaped medium. A plasma-polymerized film is formed on a surface of the member wherein the film contains C, F and at least one element of Si, B, P, and N.

Finally, document US4598022 discloses a one-step plasma treatment for improving the laminate adhesion of metallic and non-metallic substrates. The treatment comprises forming a plasma of a polar containing organic species and at least one of nitrogen and hydrogen and exposing a substrate material to the plasma for a period of time sufficient to deposit a polymeric film on at least one surface. In a preferred embodiment, a plasma of an azole, nitrogen and/or hydrogen is utilized.

### DISCLOSURE OF THE INVENTION

According to the present invention, there is provided a method for surface processing by plasma polymerization of a surface of a metal or of an insulating material by using a DC discharge plasma, according to claim 1 to 10.

There is also provided a method for surface processing by plasma polymerization of a surface of a materials induding a metal, a ceramic or a polymer by using an RF discharge plasma; according to claim 11 to 15.

There are also provided a polymer with excellent hydrophilicity or hydrophobicity and a polymer with strong coating and corrosion-resistant properties according to the above-described methods.

### BRIEF DESCRIPTION OF THE DRAWINGS

Figure 1 is a schematic view illustrating a device for a plasma polymerization for embodying the present invention;
Figure 2 illustrates FT-IR spectra of an object polymerized on its surfaces at a cathode side and an anode side by DC discharge of acetylene and nitrogen;
Figure 3 is a graph illustrating FT-IR spectra examined by changing a mixture ratio of acetylene to nitrogen during the DC discharge thereof under the conditions of a discharge 'voltage of 1 kV, a discharge current density of 2 mA/cm² and an entire vacuum degree of 40 Pa.
Figure 4 is a graph illustrating a change in the FT-IR spectra with annealing temperature after annealing a polymer polymerized at the anode and the cathode for 1 hour when the ratio of acetylene to nitrogen is 1:1 under the conditions of a discharge voltage of 1 kV, a discharge current density of 2 mA/cm² and an entire vacuum degree of 40 Pa.
Figure 5A is a graph illustrating the XPS spectra obtained from polymers at the anode side by the DC discharge for 1 minute (pressure: 40 Pa, current: 2 mA/cm², voltage: 1kV, acetylene : nitrogen = 5:5);
Figure 5B is a graph illustrating an XPS spectra after annealing of the polymer in Figure 5A;
Figure 6 is a graph illustrating an FT-IR spectra of an RF-discharged polymer on a passive electrode, when the ratio of acetylene to nitrogen is varied under the conditions of 40 Pa gas pressure, 200 W RF discharge power and 2 minutes process time;
Figure 7 is a graph illustrating the change in the water-drop contact (wetting) angle on an Al substrate having a polymerized surface when the RF power is varied under the conditions that the ratio of nitrogen to acetylene is set to be 9:1 and the gas pressure is fixed during the RF discharge;
Figure 8 is a graph illustrating the change in the contact (wetting) angle when the discharge power and the ratio: of acetylene to nitrogen are varied;
Figures 9A and 9A are SEM micrographs illustrating the surface of a polymer with hydrophilicity among the polymers polymerized by the DC discharge photographed by scanning electron microscope;
Figure 10 is a SEM micrograph illustrating the surface of a polymer with hydrophobicity among the polymers polymerized by the DC discharge photographed by scanning electron microscope;
Figure 11A and 11B are SEM micrographs illustrating the surface of a polymer with hydrophilicity among the polymers polymerized by the RF discharge photographed by scanning electron microscope;
Figure 12 illustrates the water spray property of an Al sheet processed according to a first embodiment of the present invention;
Figure 13 is a graph illustrating the pressure change of Acetylene in the vacuum chamber DC-discharged under various conditions after an initial pressure is set to 20 Pa.
Figure 14 is a graph illustrating the total pressure change with the lapse of time after acetylene and nitrogen are mixed at a ratio of 50:50 in the vacuum chamber, the pressure is set to 40 Pa , and the DC discharge is started under various conditions;
Figure 15A is a graph illustrating the partial pressure changes of the each of acetylene and nitrogen with the lapse of time after acetylene and nitrogen are mixed at a ratio of 50:50 in the vacuum chamber, the pressure is set to 40 Pa , and the DC discharge is started at 500 mA;
Figure 15B is a graph illustrating the thickness change of a polymer polymerized onto the anode and cathode with the lapse of time after acetylene and nitrogen are mixed at a ratio of 50:50 in the vacuum chamber, the pressure is set to 40 Pa, and the DC discharge is started under various conditions;
Figure 15C is a graph illustrating the contact (wetting) angle change of a polymer with the lapse of time after acetylene and nitrogen are mixed at a ratio of 50:50 in the vacuum chamber, the pressure is set to be 40 Pa, and the DC discharge is started under various conditions;
Figures 16A and 16B are graphs respectively illustrating the change of thickness and contact (wetting) angle of the polymer with the lapse of the DC discharge time, and solid lines and dashed lines represent respectively characteristics of the deposited film with and without adding a acetylene gas (5sccm);
Figures 17A and 17B are graphs respectively illustrating the change in deposition rate and contact (wetting) angle of the polymer with the time between current pulses of the DC discharge;
Figure 18 is a graph illustrating a change of contact angel of the polymer with the lapse of the time at various conditions;
Figure 19 is a schematic view of an arrangement for polymerizing an organic polymer on an insulator by using the DC discharge;
Figure 20 illustrates the change in the contact (wetting) angle with the lapse of a process time after a hydrophilic polymer is polymerized on a polyethylene teraphalate (PET) film which is processed by mixing acetylene gas and nitrogen gas at a ratio of 1:1 and using the DC plasma discharge under the discharge conditions of 1 kV and 2 mA/cm²;
Figures 21A and 21 B respectively illustrate an XPS spectra of the PET film before and after performing a surface-processing by using the DC plasma;
Figure 22 illustrates an embodiment of the present invention for performing a spray test after a hydrophilic polymer is polymerized on a polyethylene teraphalate (PET) film which is processed by mixing acetylene gas and nitrogen gas at a ratio of 1:1 and using the DC plasma discharge under the discharge conditions of 1 kV and 2 mA/cm²;
Figure 23 illustrates an embodiment of the present invention for performing the spray test after a hydrophilic polymer is polymerized on a goggle made of polycarbonate (PC) by using the DC plasma discharge;
Figure 24 illustrates the change in a contact (wetting) angle with the O₂ plama treatment time after a polymer is polymerized on a metal surface by using the DC plasma;
Figure 25 is a photograph illustrating a hydrophobic property when a polymer polymerized according to the DC plasma polymerization by using C₂H₂F₂ (vinylidenefluoride) is contacted by water;
Figure 26 illustrates a test result of painting a surface of an Al panel on which a polymer formed according to the plasma polymerization of the present invention was polymerized for 30 seconds and of testing the adhesion thereof by a tape experimental method;
Figure 27 is an enlarged photograph of the substrate in Figure 26;
Figure 28 illustrates a test result of painting a surface of the polymer which was polymerized for 60 seconds under the identical conditions to Figure 26 and of testing the adhesion thereof by the tape experimental method;
Figure 29 illustrates a test result of the corrosion-resistant properties of a polymer, a bust at the left side being a bust made of bronze which is not processed, a bust at the right side being a bust on which the polymer was deposited by the plasma polymerization and both busts are soaked in in 5% NaCl solution for 3 days.

### MODES FOR CARRYING OUT THE PREFERRED EMBODIMENTS

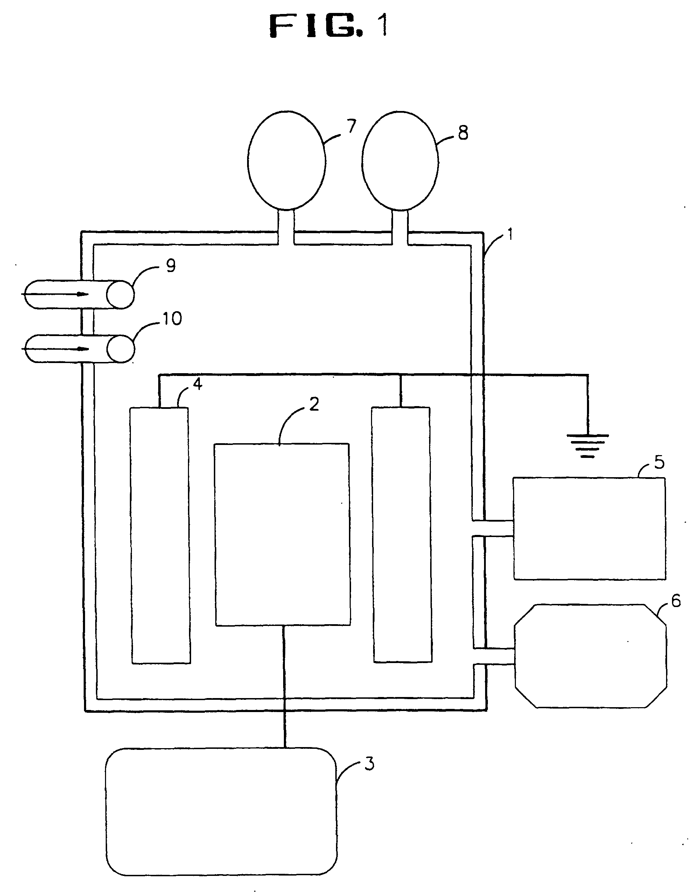

Figure 1 illustrates a schematic view of a experimental device used for the present invention. The device basically includes: a vacuum chamber; a vacuum pump for evacuating the vacuum chamber; a unit for measuring a vacuum degree; a power supplying unit for generating an electric potential difference to a substrate to be surface-processed; a substrate holder for fixing the substrate; and a reaction gas controller for blowing a reaction gas around the substrate.

A substrate 2 is provided in the chamber 1. Whether the internal pressure of the chamber 1 is maintained at a vacuum state of about 0,13 Pa by driving a rotary pump 6 is confirmed by a thermocouple gauge 7. Then, whether the internal pressure thereof is maintained at about 0,13 x 10⁻³ Pa by driving a diffusion pump 5 is confirmed by an ion gauge 8. The substrate 2 is biased to an anode (or passive electrode) by a power supply 3. An electrode 4 at the opposite side is grounded. When the chamber 1 is maintained at a predetermined vacuum state, a reaction gas comprising an unsaturated aliphatic hydrocarbon monomer gas such as acetylene 9 and nonpolymerizable gas such as nitrogen 10 is sequentially blown into preferred positions. A mixture ratio of the reaction gas is controlled by the thermocouple gauge 7. When the gas in the vacuum chamber reaches a predetermined pressure, it is discharged by using DC or RF. Here, molecular bonds in the reaction gases are broken in a plasma generated by DC or RF. Broken chains and activated cations or anions are combined, thus forming a polymer on a surface of the substrate positioned between the electrodes. The substrate is mostly made of metal aluminum Al, but may be made of insulator, ceramics or polymer.

### Anode and Cathode

The polymer can be polymerized both at the anode and the cathode by DC power applied in order to form the plasma during the plasma polymerization. Here, the polymers polymerized at the anode and cathode have different properties respectively. The ions, radicals and free electrons formed in the plasma are polymerized dependent on the polarity of the electrode by receiving energy by electrical attraction. Here, negatively charged particles and the free electrons formed in the plasma are drawn toward the anode, and positively charged particles are drawn toward the cathode. That is, different kinds of energetic particles are polymerized at the anode and the cathode respectively, and thus the polymers polymerized at the anode and cathode have different properties, which is confirmed by an FT-IR analysis.

According to the present invention, the FT-IR (Fourier transform infrared/raman spectrometer) spectra are obtained by BRUKER. IFS120HR.

Yasuda et al. ("Plasma Polymerization", Academic Press, 1985) studied the plasma polymerized film deposited on the metal inserted between anode and cathode by a glow discharge of acetylene and have found that FT-IR signals are increased at a carbonyl region (ketone and aldehyde generally absorbs at 1665-1740 cm⁻¹). They also found that signals at a hydroxyl O-H bond stretching band (3200-3600 cm⁻¹) are more remarkably increased than C-H stretching signals (about 2900 cm⁻¹), and that the concentration of the free-radicals is decreased by elapse of time. When the concentration of the free-radicals was measured by ESR (electron spin resonance) for 15 months, it was reduced to 87%. Reduction of the free-radicals progressed very slowly like oxidation of the polymer. It shows that the radicals were stable and oxygen is not infiltrated into the layer. Accordingly, stability of radicals and non-infiltration of oxygen is due to the highly branched and highly cross-linked network.

The existence of the highly branched network can be recognized by the infrared ray spectra without a signal from a Methylene chain. A strong and broad O-H stretching absorption shifts down from high to low 3000 cm⁻¹ region by an intra-molecular hydrogen bond, which suggests that it is a branched hydrocarbon polymer.

Therefore, the glow discharge polymer of acetylene is the highly cross-linked and highly branched hydrocarbon polymer including the free radical of high concentration. When the filim exposed to the atmosphere, free radicals are reacted with oxygen resulting in formation of carbonyl and hydroxyl groups. It may be advantageous in hydrophilicity.

However, in accordance with the present embodiment, the polymer is polymerized by varying a partial pressure of acetylene and nitrogen gas influencing hydrophilicity.

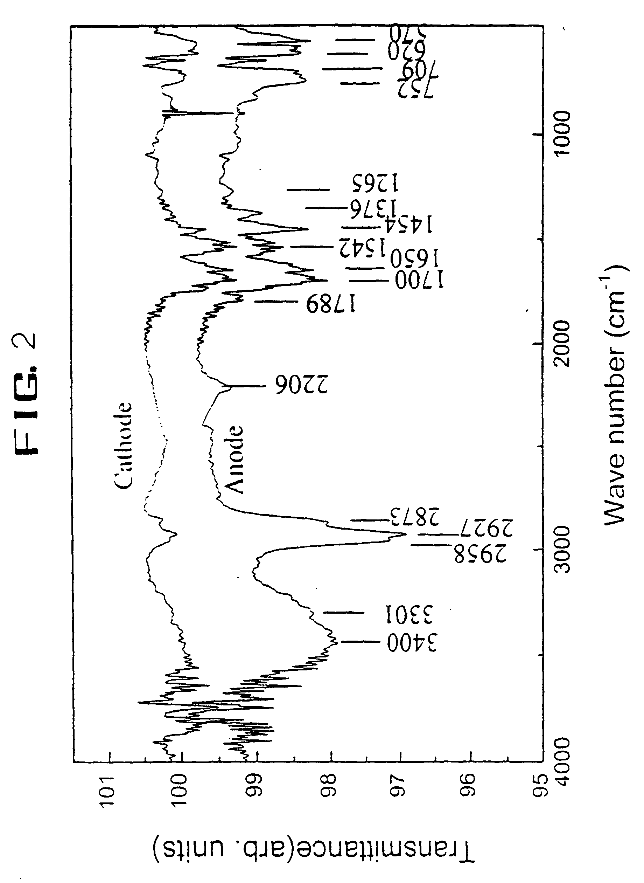

Figure 2 illustrates the FT-IR spectra of an object polymerized on aluminum substrates at the cathode and anode by DC discharge of acetylene and nitrogen. The two substrates were obtained by performing the DC discharge of acetylene and nitrogen for 1 minute (pressure: 40 Pa , current: 2 mA/cm², voltage: 1 kV, acetylene: nitrogen = 5:5). The spectra show that there is a large difference between the two substrates according to their positions.

As shown in the spectra, the largest peak of the anode polymer is at approximately 2930 cm⁻¹, which is generated by C-H stretching and C-H deformation oscillation and observed typically in a polymer such as polyethylene. It implies that the polymerized layer has a similar structure to polyethylene. However, in the case of the polymer deposited on the cathode, the highest peak is between 1700-1400 cm⁻¹. In this region, the peaks originated from the oscillations by the bonds between carbon and oxygen such as carbonyl (C=O), or the peaks orginated from the oscillations by the bonds between carbon and nitrogen such as amide, amino, amine (C=N) are repeatedly shown. The peak around 2930 cm⁻¹ is not remarkable, differently from the anode side. It implies that the hydrogen bonding of carbon is much reduced in the polymer at the cathode side. That is, the acetylene plasma formed by the polymerization forms various types of ions, and the different types of ions are moved to and polymerized at the anode and cathode. Especially in the case of the cathode, it implies that a layer which is remarkably different from acetylene is polymerized. Another strong peak is shown at the range of 3200 cm⁻¹. This peak includes an O-H group and a C-N group.

Another difference between the anode layer and cathode layer is the intensity of CH₂ rocking motion in aliphatic hydrocarbon. A peak shown around 710 cm⁻¹ caused by the CH₂ rocking motion is relatively weaker both at the anode side and the cathode side than a peak around 710 cm⁻¹ in pure polyethylene. The absorption is not strong in the region between 720 and 770 cm⁻¹ due to C-H₂ rocking. The peak is a characteristic peak from a straight chain of four or more methylene groups. This peak is not observed in the plasma polymer because a highly branched hydrocarbon chain is formed therein. As shown in the polymer, considering a C-H stretching band at about 2930 cm⁻¹ and a C-H bending mode at about 1400 cm⁻¹, it is recognized that a highly branched but basically hydrocarbon-based polymer is formed. Here, it is notable that the ratio of the C-H stretching band at 2930 cm⁻¹ to the C-H₂ stretching band at 720 cm⁻¹ is much greater at the anode than the cathode. That is, it implies that, although the hydrocarbon-based polymer is polymerized, the anode side has a more highly cross-linked structure than the cathode side. Such a result shows that the different types of polymers are polymerized according to the substrate position. As discussed earlier, the polymers deposited at the anode and cathode are of different nature. However, the polymers deposited at the anode and cathode all have a excellent hydrophilic property. The polymer deposited at the anode has remarkably strong adhesion to the substrate material, as compared with the polymer deposited at the cathode. Therefore, in case the polymer at the cathode is employed as a product, it may not be stable and a life span thereof may not be long. It is inferred that the weak adhesion of the polymer at the cathode results from increased damage due to the bombardment of positively charged energetic particles, and a weak bonding between the substrate material and the polymer. On the other hand, the polymer deposited at the anode has a excellent hydrophilic property and strong adhesion to the substrate material, thus satisfying the functional polymerization and application thereof. As a result, in the first embodiment of the present invention employing the DC discharge, a functional polymer is polymerized preferably at the anode by using the plasma polymerization.

### Change in Gas Mixture Ratio

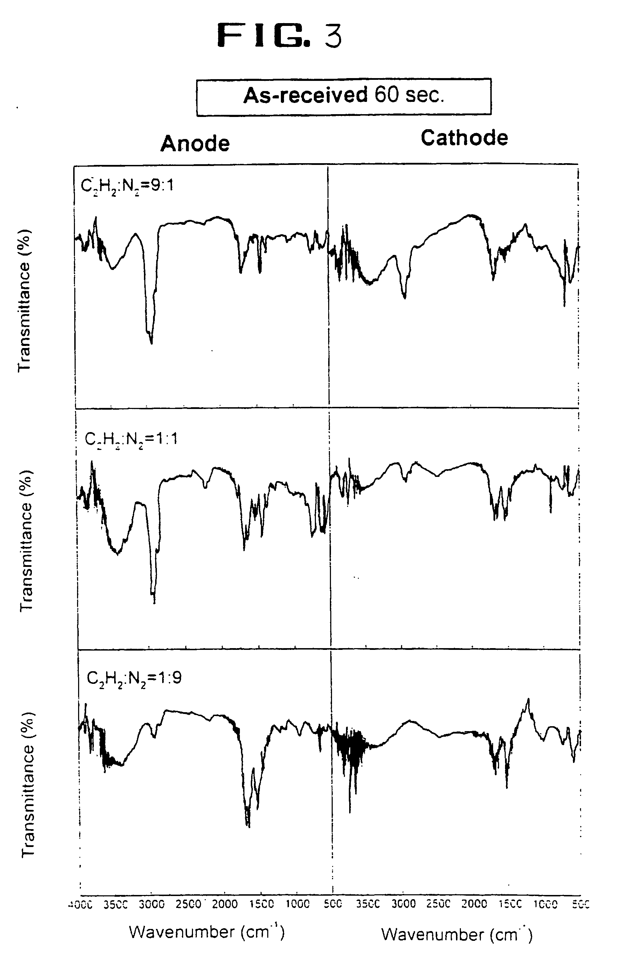

Figure 3 illustrates the FT-IR spectra examined by changing the mixture ratio of acetylene and nitrogen. As the concentration of nitrogen increased, a peak between 1700 and 1400 cm⁻¹ increased. As shown in Figure 3, as the concentration of nitrogen increased, the peak between 1700 and 1400 cm⁻¹ caused by the bonds of C=O and C=N relatively increased, as compared with a peak at about 2930 cm⁻¹ caused by the C-H stretching. A peak at about 1700 cm⁻¹ is deemed a peak caused by the bond of C=O (aldehyde or kepton). A peak between 1660 and 1600 cm⁻¹ may be a peak caused by the bonds of C=N, C=O (amide, amino acid) and N=H (amine, amide). A peak at about 1400 cm⁻¹ is a peak caused by C=N or C=C stretching. As illustrated in Figure 3, it is noticeable that the intensity of a peak between 1700 and 1630 cm⁻¹ is much varied when the concentration of nitrogen increased. As the concentration of nitrogen increased, the peak intensity at about 1630 cm⁻¹ gradually increased. It implies that the peak at about 1630 cm⁻¹ is related with a nitrogen compound, such as an amino acid, amine and amide. The increase of nitrogen compounds acts as a hydrophilic functional group, which reduces the contact (wetting) angle. That is, a layer formed by increasing the ratio of nitrogen in a mixture gas for forming the plasma is hydrophilic. It provides a clue for a change of the contact angle.

There has previously been provided just a little information regarding acetylene discharge dissociation. It has been known that positively discharged particles, negatively discharged particles and free radicals are generated in the plasma. According to the present invention, they can be separated by the DC discharge at the anode and cathode. The different polymerizations take place at the anode and cathode due to difference of ion species moved to the anode and cathode. This phenomenon was observed by an experiment on the present invention. A deposition rate of the cathode layer is a little higher than that of the anode. An oscillation mode corresponding to various chemical bonds of a discharge polymer is shown in Table 1.

**[TABLE 1]**

| Oscillation modes corresponding to various chemical bonds at the anode and cathode sides of an acetylene polymer and an acetylene + nitrogen polymer by the DC discharge polymerization. | | | | | |
|---|---|---|---|---|---|
| Absorption Region Cm⁻¹ | Source | Monomer System | | | |
| | | C₂H₂ | | C₂H₂ + N₂ | |
| | | Anode | Cathode | Anode | Cathode |
| 3200-3600 | O-H stretching, hydroxyl bond | - | S | - | No data |
| 3400-3500 | N-H stretching, primary amine | - | - | S | |
| 3310-3350 | N-H stretching, dialkylamine | - | - | S | |
| 3270-3370 | N-H stretching, NH bond secondary amide, *trans* | - | - | S | |
| 3140-3180 | N-H stretching, NH bond secondary amide, *cis* | - | - | - | |
| 3070-3100 | N-H stretching, NH bond secondary amide, *cis* or *trans* | - | - | - | |
| 2952-2972 | C-H asymmetric stretching, methyl | S | S | S | |
| 2862-2882 | C-H symmetric stretching, methyl | S | S | S | |
| 2916-2936 | C-H asymmetric stretching, methylene | S | S | S | |
| 2848-2863 | C-H symmetric stretching, methylene | - | - | - | |
| 2760 | C-H, aliphatic aldehyde | VW | VW | VW | |
| 2206 | C=C stretching | W | - | VW | |
| 2089 | | - | M | - | |
| 1955 | | W | - | - | |
| 1880-1895 | | - | M | W | |
| 1800-1815 | | VW | M | W | |
| 1700-1740 | | W | - | M | |
| 1710-1740 | C=O stretching, saturated aldehyde | W | - | M | |
| 1705-1725 | C=O stretching, saturated ketone | W | - | - | |
| 1680-1705 | C=O stretching, unsaturated aldehyde | W | - | - | |
| 1665-1685 | C=O stretching, saturated ketone | - | - | W | |
| 1630-1670 | C=O stretching, tertiary amide | - | - | S | |
| 1630-1680 | C=O stretching, secondary amide | - | S | S | |
| 1560-1640 | N=H band, primary amine | - | - | S | |
| 1515-1570 | N=H band, secondary amide | - | - | S | |
| 1490-1580 | N=H band, secondary amine | - | - | S | |
| 1445-1485 | N=H asymmetric band, methylene | W | W | | |
| 1430-1470 | C=H asymmetric band, methyl | S | W | S | |
| 1325-1440 | C=C aldehyde | - | W | - | |
| 1370-1380 | C=H symmetric band, methyl | W | W | W | |
| 1250-1290 | C=O val. aromatic, alcohol | W | VW | M | |
| 1050-1200 | C=O val., ether | S | - | S | |
| 1024 | | - | M | - | |
| 993 | C=C different, C-H, CH₂ | M | - | M | |
| 950-970 | | - | W | M | |
| 768-800 | C=C, C-H, CH₂, aliphatic | W | W | M | |
| 640-760 | CH₂ rocking, aliphatic | S | W | - | |
| 638-646 | | - | S | S | |

### Influences of Annealing

The contact (wetting) angle of the substrate measured in each condition by a contact anglemeter was between 28° and 120°. When the polymerized substrate was maintained in ambient atmosphere, 250°C for 2 hours, the contact (wetting) angle of the substrate which had an initial contact angle of 120° was reduced to 58°, and the contact angle of the substrate which had an initial contact angle of 28° was reduced to 16°. It is because the radicals which are not bonded are reacted with reactive gases in the ambient atmosphere by heating of the polymer, thus increasing the concentration of the hydrophilic group.

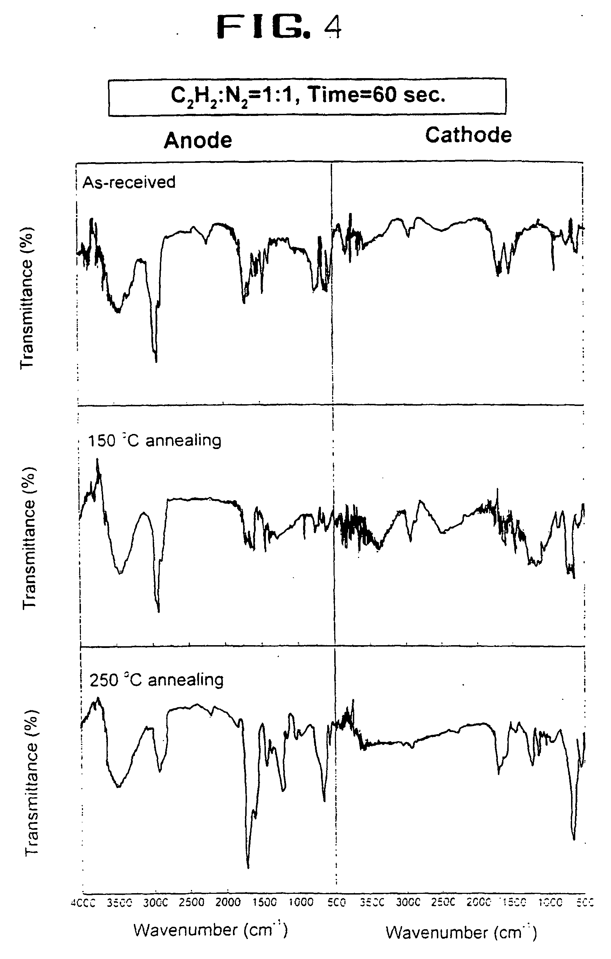

Figure 4 illustrates the change in the FT-IR spectra with the lapse of annealing time. As shown therein, the size of a peak caused by the bonds of C=O and C=N between 1700 and 1400 cm⁻¹ is remarkably increased depending on the annealing temperature, as compared with a peak caused by the C-H oscillation at about 2930 cm⁻¹. That is, the annealing at the ambient atmosphere increase the concentration of the hydrophilic group, such as a carbonyl group, amine group. The increase of the hydrophilic group improves the hydrophilic property of the surface. Actually, a peak at about 1700 cm⁻¹ caused by the peak bond (C=O : aldehyde or kepton) and a peak between 1660 and 1600 cm⁻¹ (C=N, C=O : amide, amino acid, N=H : amine, amide) are increased in intensity. It is similar to change in the FT-IR spectra caused by the change in the mixture ratio of acetylene to nitrogen. Due to the annealing, the radicals which are not bonded during the plasma polymerization are reacted, and thus the hydrophilic groups, such as C=O(aldehyde or kepton), C=N, C=O(amide, amino acid) and N=H(amine, amide) are increased, thereby reducing the contact angle.

### XPS Analysis

In general, the above-described FT-IR method and an XPS method have been widely used as analysis methods for analyzing the polymer composition and examining its chemical state. According to the present invention, an XPS spectrometer having a non-monchromatized Al K-α source is employed to compare the elemental ratio of C, N and O of the polymer formed by the plasma polymerization. In an extracted discharge polymer, the relative elemental ratio of nitrogen X_{N} to carbon X_{C} is determined by the intensity (I) of the peak under the consideration of the ratio of the available cross-section (for example, X_{C} = 100%) of electrons emitted from each element under X-ray irradiation. An element ratio of oxygen is determined by a similar method.

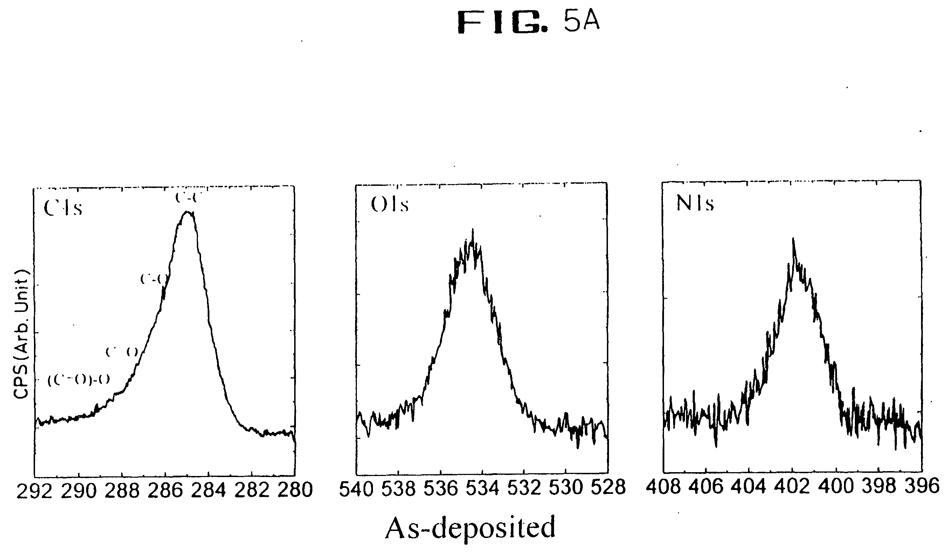

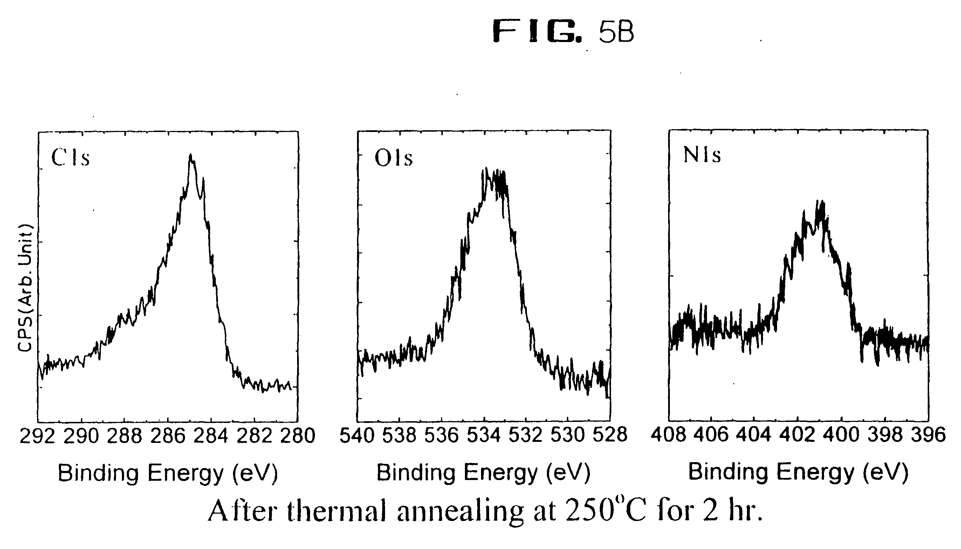

Figure 5A illustrates the XPS spectra obtained from the polymer obtained at the anode side by the DC discharge for 1 minute (pressure: 40 Pa, current: 2 mA/cm², voltage: 1KV, acetylene : nitrogen = 5:5). Although the layer. was polymerized by maintaining acetylene and nitrogen in a plasma state, a large amount of oxygen is detected. It is thus inferred that oxygen did not exist in the supplied mixture gas, but may remain in the vacuum chamber and join the reaction. It is also considered that the radicals formed during the reaction were reacted with oxygen having strong reactivity and formed an oxygen mixture when exposed to the atmosphere. As shown in the C1s spectra of Figure 5a, the C-C bond which most polymers contain is appeared at a position of 285 eV. In the case of a polymer formed by the plasma polymerization, the position of the C1s peak is identical to 285 eV, but the peak forms an asymmetrical shape. The asymmetric property results from the bond of carbon and oxygen or carbon and nitrogen, such as C-O, C=O, C-N and C=N. The peaks assigned to C-O, C=O, C-N and C=N appeared at higher than 285 eV so that the peak shaep became asymmetric. It thus implies that the layer includes the hydrophilic functional group.

As illustrated in the XPS spectra after performing the annealing, the peak of oxygen or nitrogen has been little changed. However, the C1s spectral peak is much more asymmetric after the annealing. It implies that the concentration of functional group, such as C-O, C=O or (C=O)-O has been increased by the annealing. Accordingly, considering the results of the FT-IR and XPS, the hydrophilic group is increased by the annealing because the radicals which are not completely reacted during the polymerization are reacted with oxygen by the annealing in the ambient atmosphere and form the hydrophilic group, such as C-O, C=O or (C=O)-O.

Table 2 shows the composition ratios by using the XPS of carbon, oxygen and nitrogen of a polymer obtained by depositing the polymer for 1 minute when the mixture ratio of acetylene and nitrogen was varied under the conditions of a pressure of 40 Pa , a current of 2mA/cm² and a voltage of 1 kV and polymerizing the polymer at the anode according to the polymerization using the DC discharge. The amount of oxygen was little influenced by that of nitrogen, while the amount of nitrogen was dependent upon its mixture ratio. It implies that oxygen in the polymer comes from an external. In addition, the increase in the concentration of nitrogen shows that nitrogen which is introduced in the form of mixture gas directly joins the reaction. Such a result is identical to the above-described FT-IR result that the peak intensity related with nitrogen compound increased.

**[TABLE 2]**

| Acetylene : Nitrogen | 9:1 | 1:1 | 1:9 |
|---|---|---|---|
| C | 89.72 | 77.91 | 76.07 |
| O | 10.28 | 11.97 | 11.57 |
| N | 0 | 10.12 | 12.36 |

The results of the FT-IR and XPS show that oxygen exists in the polymer and the mixture ratio of the nitrogen gas introduced during the polymerization remarkably influences the properties of the polymerized layer. Such an oxygen or nitrogen compound serves to change the polymer from hydrophobicity to hydrophilicity according to the concentration of nitrogen and oxygen. Especially, nitrogen directly joins the reaction and changes the property of the polymer.

### RF discharge

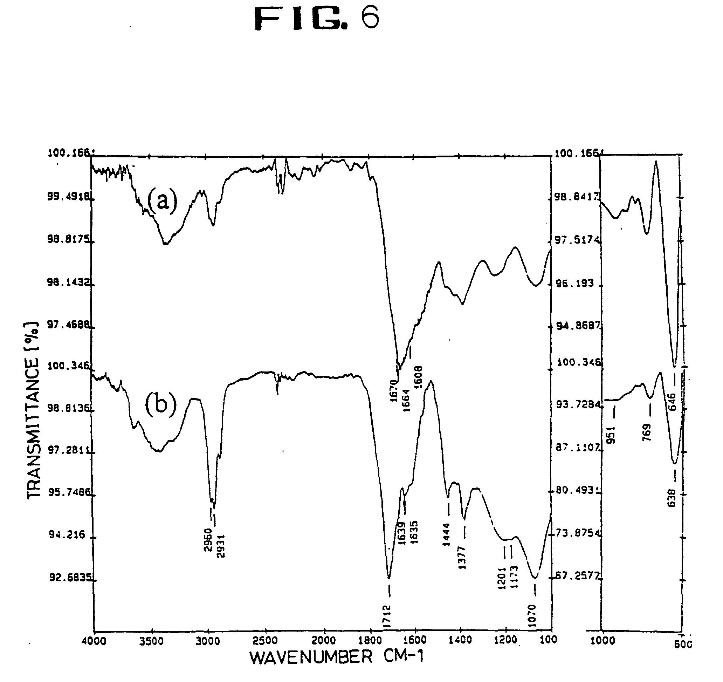

Figure 6 illustrates FT-IR spectra obtained from the polymer deposited on the passive electrode by using the RF-discharged gas mixture with varying the mixture ratio of acetylene and nitrogen. As shown therein, (a) is an FT-IR spectra obtained from a polymer deposited by RF-discharged gas mixture of acetylene (10%) and nitrogen (90%) at a total gas pressure of 40 Pa with the RF energy of 200W for 2 min. The contact (wetting) angle on this film was lower than 5°. While, (b) is a FT-IR spectra of a polymer obtained under the same conditions as (a) except that the mixture ratio of acetylene (70%) and nitrogen (25%), wherein the contact (wetting) angle of the film was approximately 180°. As shown in Figs. 2, 3, 4 and 6, the spectra of the polymers which have been obtained from the acetylene, and the mixtures of acetylene and nitrogen by the DC and RF discharges are quite similar to spectra which have been disclosed in the conventional art. Furthermore, as can be seen from papers such as Ivanov, S.I., Fakirov, S. H, and Svirachev, D. M. Eur. Polym. J. (1997, 14, 611), FT-IR spectra obtained from the polymer deposited by acetlylene plasma and those deposited by high energy tolune plasma have similarities. Nevertheless, in general, relative intensity of peaks of the spectra varies as the discharge power increases. Accordingly, in view of the peak intensity of the FT-IR spectra, it is shown that the polymer obtained by the plasma polymerization is strongly dependent on the discharge power.

One of the most important peaks which are shown among all of the polymers is the one shown in the vicinity of 3430cm⁻¹. Particularly, a peak of 2965cm⁻¹ and a relatively weak peak of 1370cm⁻¹ are originated from stretching and deformation vibration of a methyl group and shows that a large amount of branching were developed' in a plasma polymer. A peak of 1700cm⁻¹ is considered to be due to vibration of a carbonyl (aldehyde or ketone). Absorption at 1630cm⁻¹ corresponds to an olefine (C=C) stretching band. The existence of a CH₂ or CH₃ deforming band at 1450cm⁻¹ shows that there are addition branches and crosslinking. A strong peak at 1100cm⁻¹ is caused by a COC asymmetric stretching of aliphatic ether or a C-O stretching of saturated ether. A band portion between 900cm⁻¹ - 600cm⁻¹ shows CH deformation of substituted benzene.

Further, a surface contact angle of a substrate obtained from the RF discharge was between 5°- 180°and by adjusting the ratio of acetylene and nitrogen the polymer can be made highly hydrophilic or hydrophobic.

The FT-IR spectra obtained from the film deposited by an acetylene-nitrogen RF plasma shows an N-H stretching, primary amine, dialkyl amine, and an amino-like property. Hydroxyl and carbonyl stretches bands and an N-H stretch and an N-H band appeared at a similar region. Since these band generate wide and strong signals, it is impossible to separate the oxygen compound signal from these band region. In accordance with quantitative analysis, the amount of oxygen remained at the acetylene-nitrogen plasma polymer is the same as that of an acetylene polymer, which means that the acetylene-nitrogen polymer is instantly oxidized by exposing to the ambient atmosphere. That is, peak intensity of carbonyl increased by exposing the substrate to the ambient atmosphere. Though the absorption effect of a hydroxyl group is not clearly shown, it is likely to be caused by coincidence of the stretching band absorption of O-H and N-H. However, a possibility of coexistence of amide and a hydroxyl or carbonyl group should not be excluded. In reality, an absorption band is considerably wide and difficult to find, and overlapped peaks are similar to some degree. When nitrogen and oxygen are combined in the same ratio, a polymer which is discharged thereby is similar to amine. Accordingly, the deposited polymer has many branches and when the film is exposed to the atmosphere, or when the substrate thereof is heat-treated, the polymer reacts with oxygen thereby it reduce time required to react with oxygen.

In XPS, nitrogen and oxygen signal appeared at 401eV (N1s) and 533 eV (O1s), respectively. Table 3 shows the relative ratio of carbon, nitrogen and oxygen which is calculated from the intensity of N1s, O1s and C1s(BE=286eV) signals, while Table 4 shows O1s binding energy depending on the O1s chemical state. Though the polymerization deposited by using the plasma which does not contain oxygen, it is common that deposited polymer contains oxygen compound and this oxygen added into polymer during or after the treatment of a plasma. Therefore, it seems that a radical intermediate serves an important role in the plasma treatment. Because such radical is unstable, it is reacted with other gases and also in heat-treatment, the radical is rapidly reacted with oxygen (peroxy radical formation). This means that oxygen.is not needed inside of plasma to form hydrophillic polymer, however a small amount of oxygen in the plasma enables a surface to be treated to have high affinity for the plasma. After the plasma treatment, the radical at the surface will react with oxygen under normal atmospheric conditions.

**[Table. 3]**

| The ratio of an elementary synthesis of acetylene-nitrogen to carbon(100%) of a surface polymer obtained by RF discharge. | | | |
|---|---|---|---|
| gas mixture ratio | RF energy | nitrogen | oxygen |
| acetylene(10%)-carbon(90%) | 200-300Watt | 12.6 | 18.5 |

**[Table. 4]**

| O1s binding energy according to the XPS | | |
|---|---|---|
| C=0 | | 531.93eV |
| C - 0 | ΔE=about 1.2eV | 533.14eV |

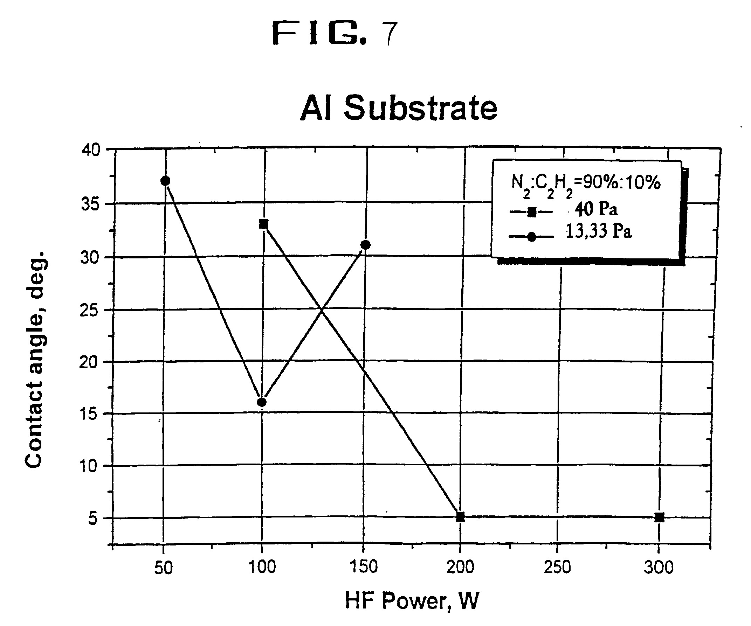

Figure 7 shows the change in contact angle under conditions where the ratio of nitrogen and acetylene is fixed at 9:1 and the gaseous pressure and RF power are varied, wherein when the gas pressure is 40 Pa and the RF power is over 200W, the contact angle is 5° which, shows desirable hydrophilicity.

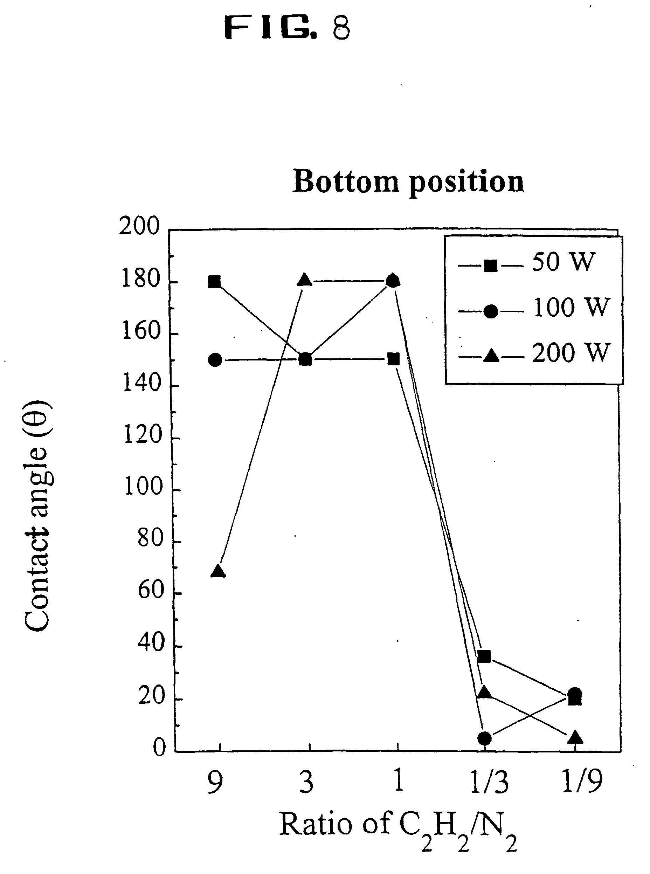

While, Fig. 8 shows the change in contact angle when varying discharge power and the ratio of acetylene and nitrogen in the RF discharge. As shown therein, the contact angle is 180° showing desirable hydrophobicity when the ratio thereof is 9:1, while the contact angle is lower than 5° showing the desirable hydrophilicity when the ratio thereof is 1:9. Thus, it is possible to modify a surface of a metal to be hydrophilic or hydrophobic by adjusting the ratio of acetylene and nitrogen. The results thereof are shown in Table. 5.

Accordingly, it is considered that a polymer layer according to the present invention can be deposited without any difficulty by applying ceramic and polymer materials to fix on a passive electrode, besides a metallic material which may be applied to an anode of a DC discharge.

**[Table. 5]**

| The contact angle of a high polymer under conditions of the position of a substrate in a vacuum chamber, gas ratio and RF power. | | | |
|---|---|---|---|
| acetylene(90%): 36 Pa nitrogen(10%): 4 Pa | | | |
| | bottom | middle | top |
| 20W | 71° | 75° | 68° |
| 50W | 180° | 67° | 82° |
| 100W | >150° | 72° | 66° |
| 200W | 68° | 75° | 78° |

| acetylene(75%): 30 Pa nitrogen(25%): 10 Pa | | | |
|---|---|---|---|
| 50W | >150° | 76° | 71° |
| 100W | >150° | 80° | 72° |
| 200W | 180° | 116° | 95° |

| acetylene(50%): 20 Pa , nitrogen(50%): 20 Pa | | | |
|---|---|---|---|
| 50W | >150° | 70° | 61° |
| 100W | 180° | >150° | 70° |
| 200w | 180° | 70° | 72° |

| acetylene(25%): 10 Pa nitrogen(75%): 30 Pa | | | |
|---|---|---|---|
| 50W 36° 23° 36° | | | |
| 100W | <5° | 50° | 53° |
| 200W | 22° | 402° | 64° |

| acetylene(10%): 4 Pa nitrogen(90%): 36 Pa | | | |
|---|---|---|---|
| 50W | 20° | 47° | 32° |
| 100W | 22° | 47° | 98° |
| 200W | <5° | 58° | 68° |

### Test results of deposited polymer

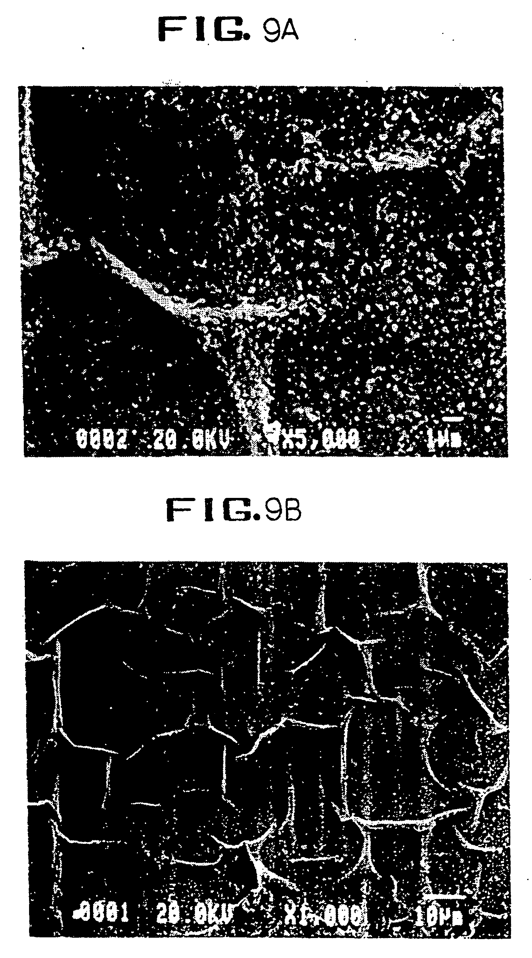

Figures 9A and 9B are SEM (scanning electron microscopy) images of deposited polymer surface which shows hydrophilicity among films deposited by the DC plasma polymerization, wherein the surface of the polymer has a velvet shape which is considered to enable the surface to have hydrophilicity.

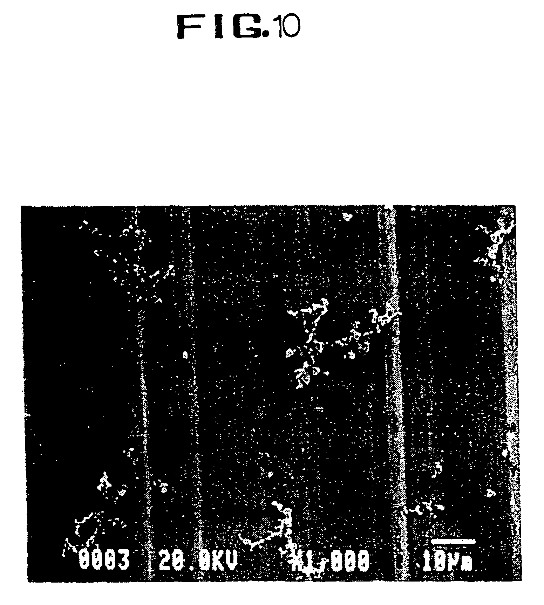

Figure 10 is a SEM image of deposited polymer surface which shows hydrophobic among films deposited by the DC plasma polymerization, wherein it shows formation of relatively large bumps by which soft particles are combined onto solid particle groups and the bump might affect the hydrophobicity.

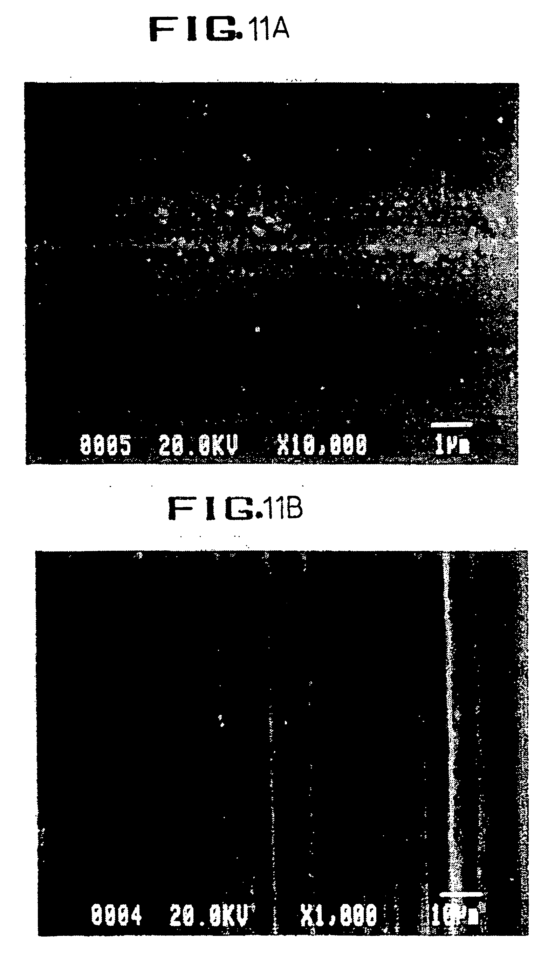

In addition, Figure 11A is SEM image of the film which is processed to the hydrophilic polymer by the RF discharge and Figure 11B is its enlargement. As can be seen therein, although the surface of the substrate looks different from the result of the DC discharge case in Figs. 9A and 9B, the surface of the polymer has a kind of velvet shape which is also considered to enable the surface to have hydrophilicity.

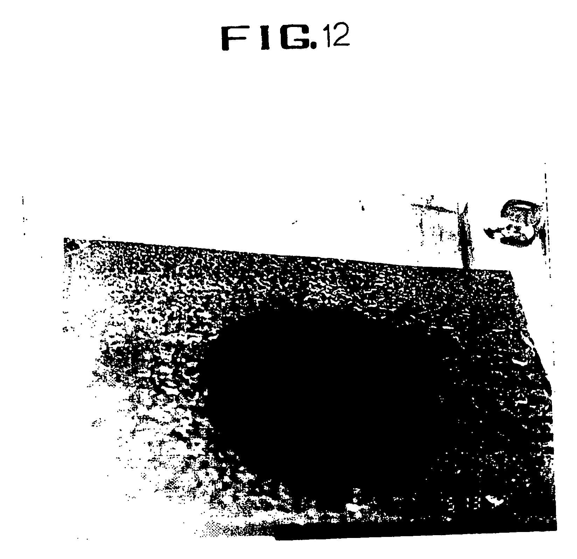

Figure 12 shows a water spray result of an Al sheet which has been treated according to the present invention. As shown therein, the are within the circle is a portion which has been treated according to the present invention, showing a good water spreading property due to a low-degree contact angle of a waterdrop, while the other area thereof which has not been treated has a high-degree contact angle, whereby water-drops form without being spread. One of the important results is that above decribed characteristics does not changed with the lapse of time, which means that the formed hydrophobic group does not wash out by water. That is, the molecular weight of synthesized polymer is considerably large.

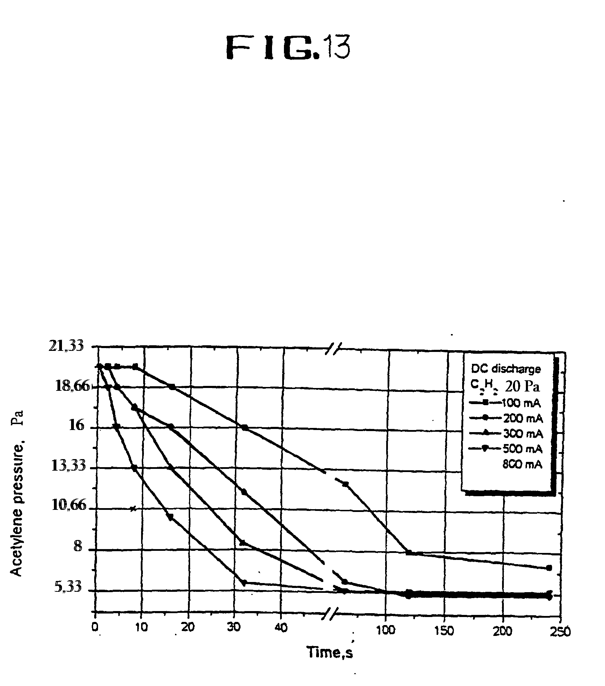

Figure 13 shows changes in acetylene pressure by the DC discharge when acetylene was blown into the vacuum chamber until the chamber pressure reaches to 20 Pa then pumping and supplement of acetylene is stopped. Here, it is noted that only the discharge current was varied without providing acetylene during the DC discharge. As shown therein, within a short period, the acetylene pressure was reduced to 5,33 Pa at the minimum in accordance with the increase in the DC current. The reason for decrease in the pressure is that the polymer is deposited onto the substrate and an inner wall of the chamber from acetylene radicals and ions. Here, since the acetylene pressure rapidly decreases as the current increases, it is shown that the more the current increases, the faster the synthesizing of the polymer is performed.

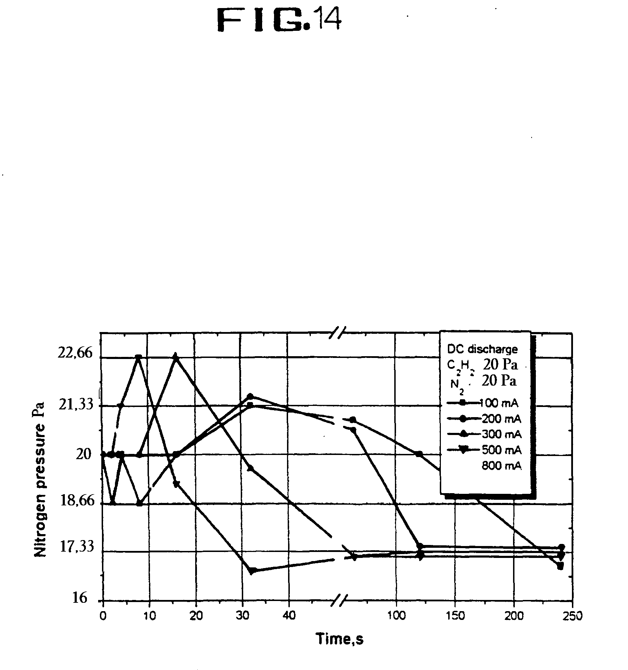

Figure 14 shows the changes of total pressure by the DC discharge under the same condition of Fig. 13 except the gas mixture ratio. The gas mixture ratio of acetylene and nitrogen was 5:5. As shown therein, when mixing acetylene and nitrogen, initial pressure rapidly increases but with the lapse of time the pressure gradually decreases. Here, the nitrogen pressure increases due to nitrogen dissociation, and the nitrogen pressure again decreases due to nitrogen incorporation. Further, as the DC current increases, the dissociation time of nitrogen gas is reduced. As shown in Fig. 14, maximum values of the nitrogen pressure shift to the left side thereof which means the time lapsed is relatively short. However, the decrease of the nitrogen pressure after the maximum value is caused by the reduction of acetylene and nitrogen due to the polymerization onto the substrate. Thus, it is shown that a certain time is required for the polymerization, the polymer is damaged by the plasma after the required time is lapsed, and a large polymer can be produced when the synthesis is accomplished within an optimum time.

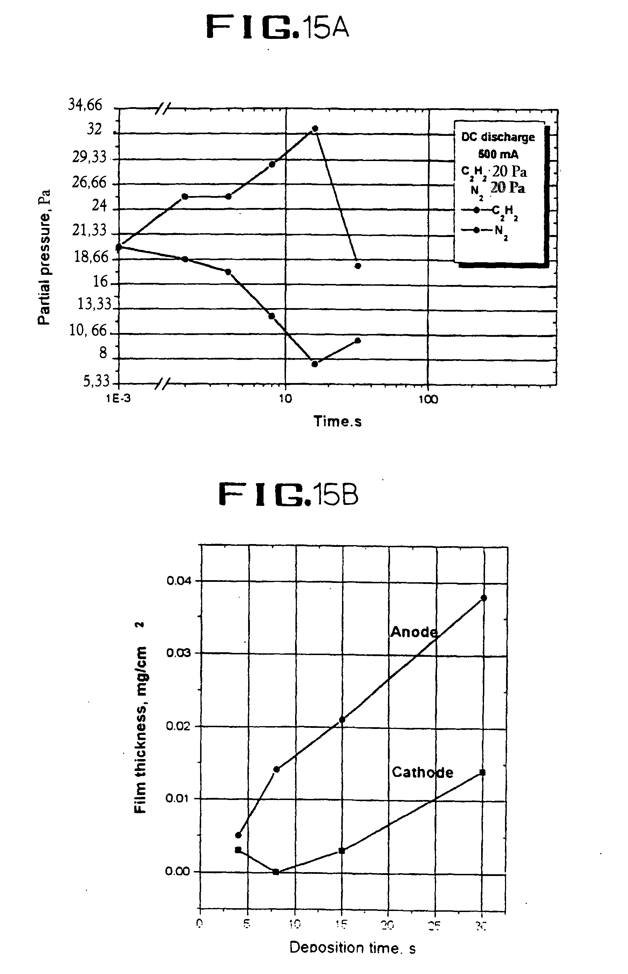

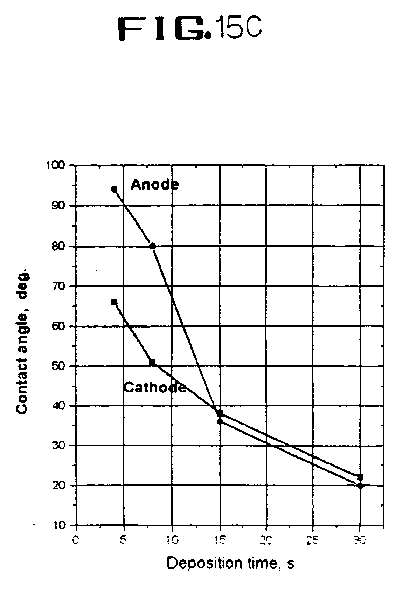

In Figure 15A, it is shown that nitrogen pressure increase and acetylene pressure decrease. Figure 15B shows the thickness of the polymer according to the discharge time, wherein the thickness thereof under 5 sec of the discharge time can be ignored since a sputtering effect of an aluminum substrate is greater than a deposition rate of the polymer. The result means that nitrogen is dissociated and then polymerization occurs and at least 5 seconds are required for the deposition of the polymer. Next, as the discharge time lengthens, the thickness of the polymer increases. As shown in the result of Figure 13, since the acetylene pressure is reduced to the minimum point at 60 sec, the thickness of the polymer no longer increases. Thus, as the acetylene pressure becomes reduced, the deposition rate of the polymer decreases, and when the deposition time is 100 sec, the thickness of the polymer is gradually reduced due to the sputtering effect. Further, Figure 15C shows that a contact angle of water under 20° after 30 sec of deposition time, which means that there exists an optimum deposition time. The concentration ratio of nitrogen and acetylene of the synthesized polymer can be estimated from initial and end pressures of acetylene and nitrogen. According to the estimation, nitrogen(20%) and acetylene(100%) are reacted at 100 sec.

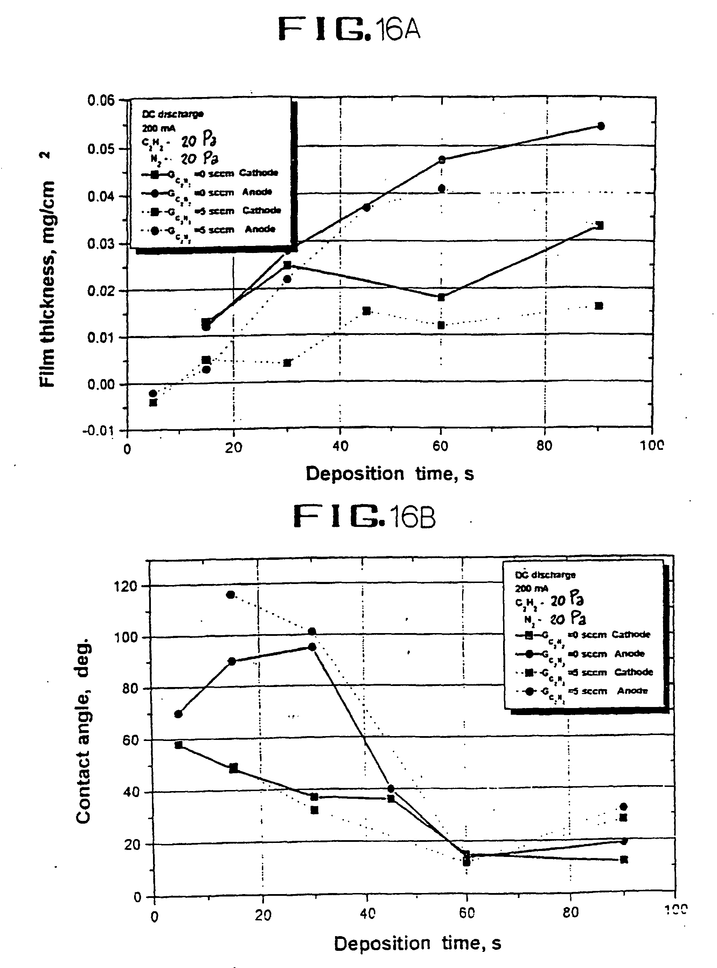

Figures. 16A and 16B show the reaction of nitrogen which is dissociated in the vacuum chamber and acetylene which is additionally flowed into the chamber, when 5 sccm acetylene is added at a cathode and an anode after the polymer synthesis of C₂H ₂ and N₂ is completed under the conditions of Figs. 15A through 15C. The synthesized polymer before additionally flowing acetylene into the chamber is synthesized to the substrate with the lapse of a certain time and thus the thickness thereof increases. However, after 60 see, the thickness thereof no longer increases and instead it is reduced. In addition, when acetylene is flowed to the thusly synthesized substrate and reaction of acetylene to remaining nitrogen is observed, the thickness of the polymer which is synthesized to the substrate is reduced from the thickness thereof before adding acetylene. In other words, the attempt to polymerize the remaining nitrogen and the additionally flowed acetylene after the reaction thereof damages the organic polymer which has been already deposited and reduces the thickness of the originally synthesized matter. Figure 16B shows the change in contact angle in accordance with the deposition time, wherein the cathode and the anode have the lowest values at 60 sec at which the gaseous pressure becomes the minimum value. Accordingly, it is the most desirable when the DC discharge polymerization is accomplished at around 60 sec. Of course, such polymerization time may vary in accordance with conditions such as current and voltage of the DC discharge, an RF voltage, etc. When the discharge is performed for over 60 sec, the polymer is worn due to the sputtering effect, which results in increase in the contact angle. As can be seen in Figs. 16A and 16B, when introducing acetylene into the chamber during the discharge polymerizing process, the thickness of the polymer increases, however the contact angle thereof decreases when the polymerization time is over 60 sec.

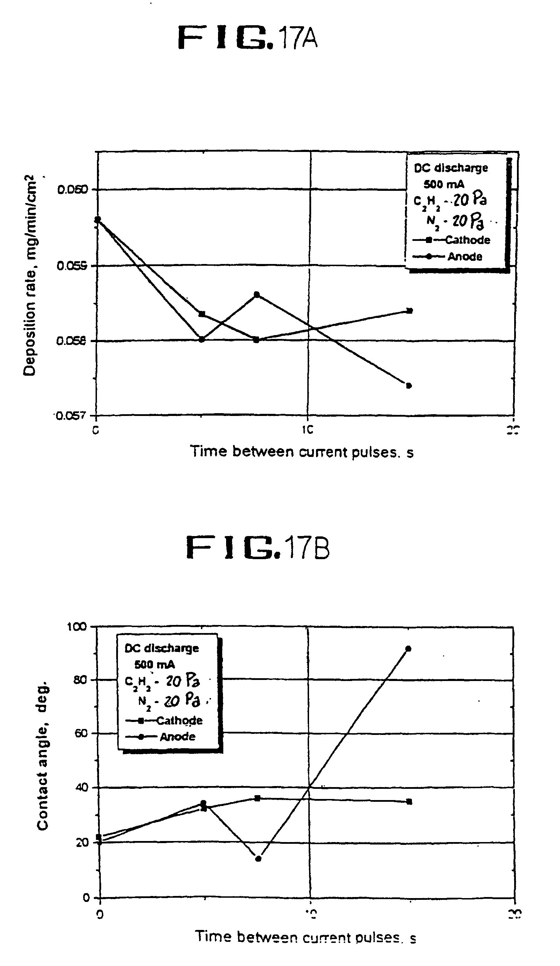

Figures. 17A and 17B show the change in deposition rate and contact angle of polymers which are obtained from a cathode and an anode, by equalizing treating time and cooling time, that is, by performing an on/off treatment for the cathode and anode in a pulse type. Here, it is noted that the total treatment time is 30 sec. As shown in Fig. 17A, when treating for 30 sec without having a cooling period, the cathode and anode have the highest deposition rate, while as the treating time decreases, the contact angle decreases as shown in Fig. 17B. Judging from this, it is found that there exists the optimum treatment time and radical, and negative and positive ions are important factors for the polymerization.

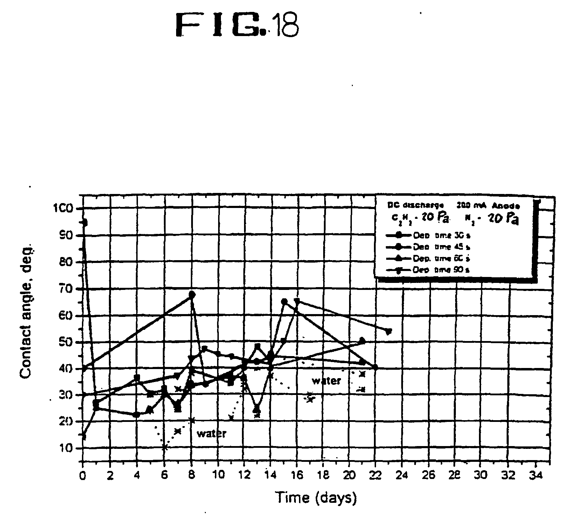

Figure. 18 is a graph showing the change in contact angle of the polymer obtained under each condition when exposed to the atmosphere and the change in contact angle of the polymer substrate when placed in water for a predetermined time and then dried with dry N₂. When exposing the polymer to the atmosphere, the contact angle thereof gradually increases, while when placing the polymer substrate in water, the contact angle little changes. Accordingly, it seems that the hydrophilic radical polymerized to the substrate rotates, and when contacted with water, the hydrophilic radical turns outwardly and thus maintains the hydrophilicity on a surface of the substrate, while when not being contacted therewith, the hydrophilic radical turns inwardly and appears not to maintain the hydrophilicity.

### Surface-Processing of Insulating Material Using DC Plasma

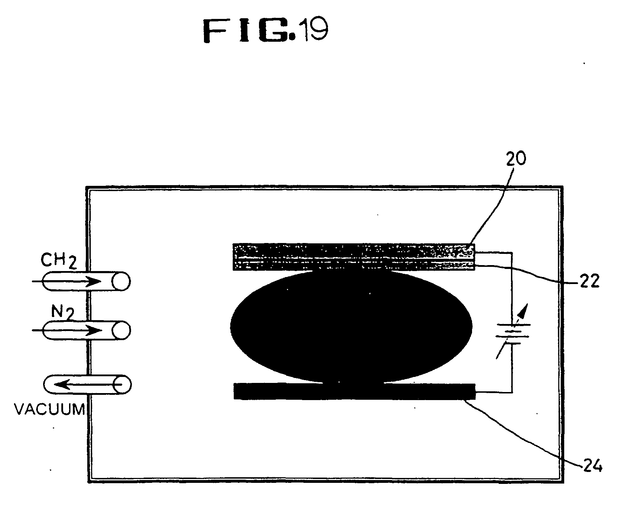

In the case of the DC plasma, the substrate is made of a metal and thus the DC plasma cannot be employed for materials such as insulators, ceramics and polymer. An RF plasma is mostly used for such materials. Figure 19 is a schematic diagram of the present invention for polymerizing a polymer on an insulator by using a DC plasma. In order to use the DC discharge, the voltage should be applied to the anode and cathode electrodes. However, in the case of the insulator, a voltage cannot be applied. Therefore, according to the present invention, a metal (Al, Cu) is used as the anode electrode 20 in order to form the plasma at the insulator side 22 in the vacuum chamber, and the polymer is adhered thereto. A metal electrode is employed as the cathode 24, identical to the conventional art. When the DC plasma is formed, as mentioned above, anions of the plasma elements are moved and polymerized on the surface of the insulator under the influence of the anode positioned at the back of the insulator, and cations of the plasma elements are deposited on the cathode side. The plasma formed by the above process is identical in property to the polymer formed on a metal surface by using the DC plasma.

Whether a layer is formed is observed by a water-drop contact angle method. Whether an organic polymer is polymerized is observed by a difference between a contact angle of a material which is processed and a contact angle of a material which is not. Generally, molecular weight of plasma polymerized film is small so that plasma polymerized film washed by water. Whether large molecular weight polymer is formed is examined by observing the change of contact angle after washing.

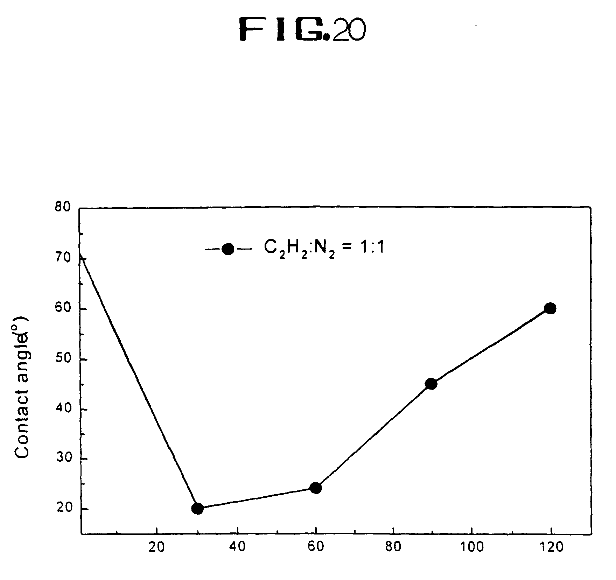

Figure 20 illustrates the change in contact angle with the lapse of process time on a polyethylene teraphalate (PET) film which were processed by mixing acetylene gas and nitrogen gas at a ratio of 1:1 under the discharge conditions of 1 kV and 200 mA/cm². As shown therein, as the process time increases, the contact angle also increases, which is similar to the polymer polymerized on the metal. In the case of the metal, as the deposition time increases, the contact angle also increases. The contact angle of the polymer to water increases with the lapse of time.

In order to examine the composition of the deposited layer, the Fourier transform infrared/raman spectrometer (FT-IR) has been generally employed. However, when a new polymer is formed on the insulator, a property of the deposited polymer is difficult to examine by FT-IR because the polymer is too thin. Accordingly, the X-ray photoelectron spectroscopy (XPS) is used to examine the property of the deposited polymer. The composition ratios of C, N and O of the polymer are compared by using the XPS spectrum.

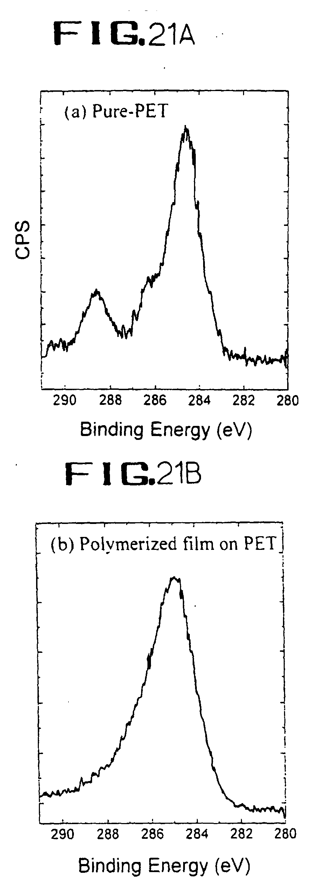

The XPS spectra of nitrogen (N1s) and oxygen (O1s) are shown at about 401 eV bonding energy, and about 533 eV bonding energy, respectively. Figures 21 A and 21 B illustrate XPS spectra respectively before and after polymerizing the polymer on the PET surface. A typical PET spectrum is shown in Figure 21A before the polymerization, and a different spectra from PET is shown thereafter in Figure 21 B. Especially, the PET does not include nitrogen, but an N1s peak is observed therein after the polymerization. That is, it implies that a new polymer is formed on the PET. The plasma employed for the present experiment did include oxygen, and thus theoretically a signal caused by oxygen cannot be generated. However, a signal caused by oxygen is detected after the polymerization. This is because oxygen is bonded on the polymer surface before/after the processing, as described above. The radicals generated during the plasma processing take an important role to form the oxygen bond. When a small amount of oxygen exists in the chamber for forming the plasma, oxygen reacts with formed polymer due to its strong reactivity, or when the polymer is exposed to the atmosphere, the radicals are reacted with oxygen at the atmosphere and form an oxygen bond. The bonding of the polymer and oxygen greatly influences change in the polymer to have hydrophilicity. The relative ratio of carbon, nitrogen and oxygen computed from XPS N1s, O1s and C1s is 100 : 18.5 : 12.6. This ratio is almost identical to the ratio of the layer polymerized on the metal anode by employing a metal both as the anode and cathode and by using the DC plasma discharge. As a result, the layer polymerized on the PET polymer in the present experiment has identical properties to the layer polymerized on the metal.

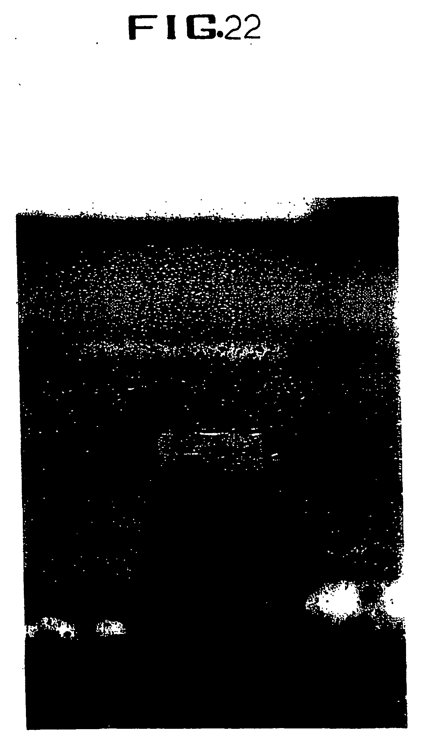

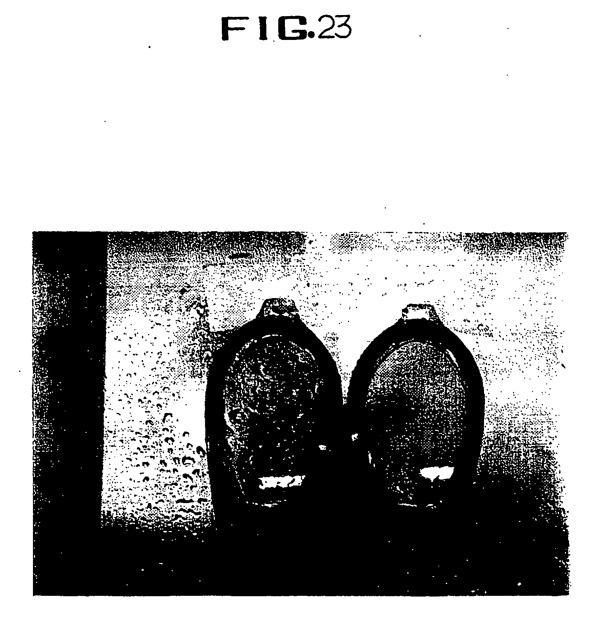

Figure 22 illustrates results of a water-drop spraying test for a PET surface which was processed by using the DC plasma and one which was not. As shown therein, in the case of the substrate which was processed, when water was sprayed thereon, water drops were not formed and the water is spread on its surface due to the formation of the hydrophilic group. However, in the case of the substrate which was not processed, water drops were formed on its surface because of the hydrophobicity which is a property of the PET polymer. As another example, Figure 23 illustrates a processing result of the inside of a goggle made of a polycarbonate (PC) which is different in nature from a PET. As illustrated in Figure 23, in the case of the substrate which is processed, when water is sprayed thereon, the water is spread due to the formation of the hydrophilic polymer, and in the case of the substrate which was not processed, water drops were formed, identically to the unprocessed PET.

### Influences of Post-Processing by Oxygen Ions on Hydrophilicity

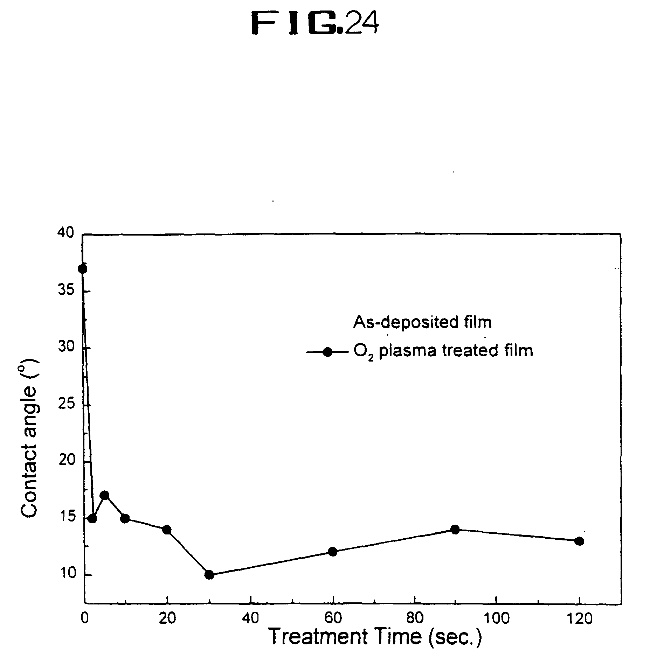

Figure 24 illustrates the change in contact angle with the lapse of processing time when a new polymer is polymerized on a metal surface by using the DC plasma and post-processed by using an oxygen plasma. In the case that the polymer is polymerized by using the DC plasma, the contact angle of water on the polymer is dependent upon conditions of the polymerization. In order to lower the contact angle of the polymer, it is processed by using an oxygen plasma in an identical experimental device after the polymerization. Here, the layer deposited on the anode is superior in adhesion and durability to the layer deposited on the cathode. During the post-processing, the electrodes are exchanged, namely anode to cathode, and vice versa. Though processed for a short time, oxygen is bonded with a surface of the polymer, thereby increasing hydrophilicity. Figure 24 illustrates the change in contact angle with the lapse of processing time when the polymer polymerized by DC plasma is post-processed by using an oxygen plasma, an initial contact angle of which being 35 degrees. As shown therein, although only processed for a very short time, the contact angle is remarkably lowered.

### Polymerization of hydrophobic polymer

A polymer with hydrophobicity can be polymerized by using a monomer containing fluorine in accordance with a process similar to the above-mentioned polymerization. Polymerization is performed using C₂H₂F₂ (vinylidenefluoride) by DC plasma polymerization under conditions that a DC current is 2 mA/cm², total pressure of the monomer in a vacuum chamber is 13,33, 26,66 and 40 Pa. respectively and polymerization time is 10 and 30 sec. Polymers obtained under the above conditions have excellent hydrophobicity and particularly a polymer, which is polymerized at an anode under the conditions of 26,66 Pa and 30 sec of polymerization time, has a property of not making any contact with water and has a 180° contact angle with water. Further, in the polymerization of the hydrophobic polymer, polymers obtained from both the anode and cathode show hydrophobicity, but the polymers which are polymerized at the anode have better hydrophobicity. Table 6 shows various contact angles of the hydrophobic polymers with water in accordance with each polymerizing condition.

**[Table 6]**

| Contact angles of the hydrophobic polymers with water in accordance with each polymerizing condition when polymerizing vinylidenefluoride to a metallic surface by using the DC discharge. | | | | |
|---|---|---|---|---|
| | 10 sec. | | 30 sec. | |
| | Anode | Cathode | Anode | Cathode |
| 13,33 Pa | 115° | 130° | 88° | 92° |
| 26,66 Pa | 130° | 125° | 180° | 130° |
| 40 Pa | 105° | 96° | 142° | 112° |

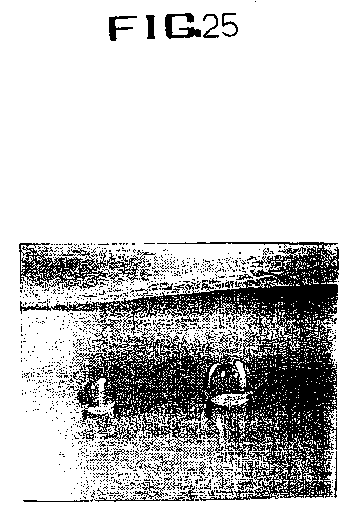

Figure 25 is a photograph showing hydrophobicity of the polymer obtained by the DC plasma polymerization by using vinylidenefluoride plasam.

The polymerization using the monomer containing fluorine can be performed by RF plasma polymerization. Table 7 shows various contact angles with water of polymers in accordance with change in RF power and polymerization time.

**[Table 7]**

| Contact angles with water of the polymers in accordance with change of RF power and polymerization time by using C₂H₂F₂ (vinylidenefluoride). | | | | |
|---|---|---|---|---|
| | 10 sec | | 30 sec | |
| | Active | Passive | Active | Passive |
| 100W | 130° | 112° | 130° | 68° |
| 150W | 110° | 82° | 88° | 60° |

As shown therein, the hydrophobic polymer achieved by the RF plasma polymerization also has excellent hydrophobicity. However, the polymers which are polymerized at the anode by the DC plasma polymerization have the best hydrophobicity among the obtained polymers. Further, as the hydrophobic material for the plasma polymerization, not only C₂H₂F₂ (vinylidenefluoride) is applied, but also other fluorine-containing monomers and a silicone-containing monomer can be applied.

### Paint adhesion test

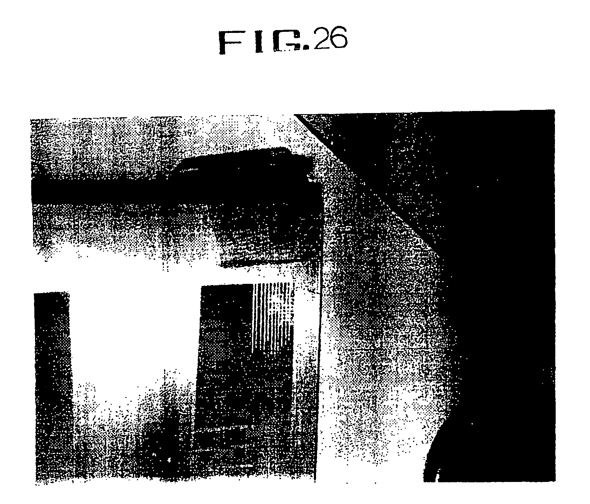

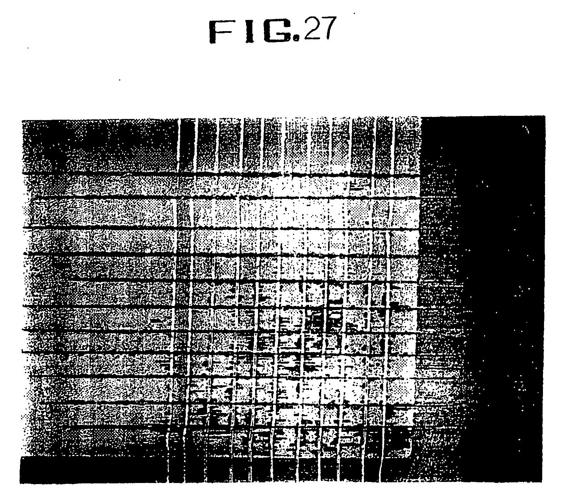

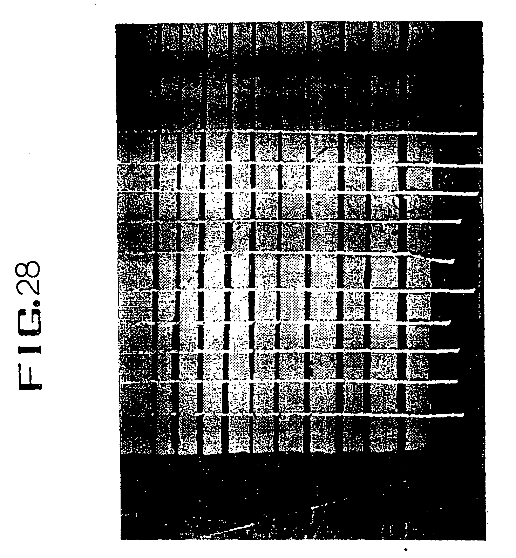

The excellent hydrophilicity obtained according to the present invention as well as an adhesion property which is closely related to the hydrophilicity can be applied to products. Since the hydrophilicity is closely related to the surface energy, the hydrophilicity and adhesion to a material, on which is be deposited or adhere to a surface of a product, improve as the surface energy increases. Since adhesion is related to the force which is required to separate materials which are stuck to each other, it is proportional to the surface energy. Accordingly, as the surface energy increases, the adhesion improves. Thus, the polymer with the excellent hydrophilicity which is achieved by the plasma polymerization can be applied to the application to improve the adhesion. Here, the improvement of paint adhesion to an aluminum panel is taken as an example. Generally, when applying paint to aluminum panel, adhesion of the paint is undesirably weak and thus the paint on the panel inevitably peels off in time. However, such problem can be solved by applying the paint to the aluminum panel after polymerizing the aluminum surface by the plasma polymerization according to the present invention. In Fig. 26, there is shown an adhesion test which is performed by a tape testing method after the plasma polymerization is applied onto the aluminum panel for 30 sec and paint is applied thereto. Here, it is noted that there is formed a square mold for the adhesion test. As shown therein, the paint partly peels off, but generally the paint applied on the panel shows excellent adhesion strength. Figure 27 is an enlarged photograph of the substrate in Figure 26, wherein except for the part in which the paint peels off, the paint applied on the polymer of the plasma polymerization show the excellent adhesion strength. In Figure 28, an adhesion test is shown, the test being performed after the plasma polymerization is applied onto the aluminum panel for 60 sec. As can be seen therein, the polymer of the 60 see-plasma polymerization has better adhesion strength than that of the 30 sec-plasma polymerization. Further, the paint applied on the polymer in Fig. 28 does not even have a peeled portion and shows the excellent adhesion strength in general. As described above, the polymer with the excellent hydrophilicity which is obtained by the plasma polymerization according to the present invention can be applied to the application to improve the adhesion.

### Corrosion-resistance test

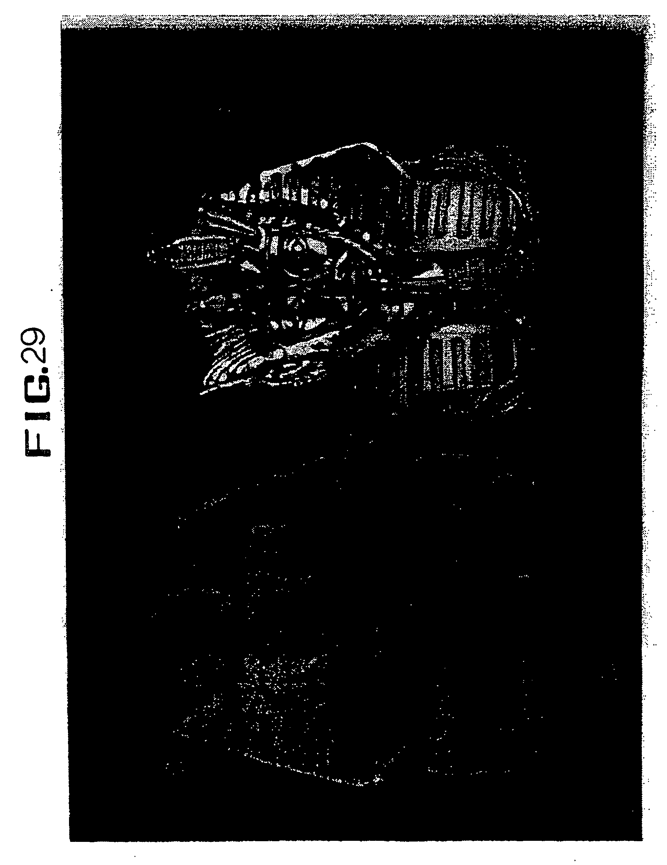

To examine the corrosion-resistance of the polymer achieved by the plasma polymerization, a bronze bust and a polymer-coated bronze bust were respectively placed in a 5% NaCl solution for 3 days and the corrosion degree of the two busts are observed. The result of the test is shown in Fig. 29. As shown therein, the bust on the left side which did not receive the plasma polymerization, was severely corroded in the 5% NaCl solution, while no corrosion occurred to the bust on the right side on which the polymer is deposited according to the plasma polymerization of the invention. Therefore, it is certain that the polymer obtained by the plasma polymerization according to the present invention has excellent corrosion-resistance.

As described above, a material with a novel chemical structure is produced on a surface of a substrate by mixing monomers of materials to be deposited on the substrate under conditions of relatively low energy and vacuum and generating a potential difference between the substrate and particles to be deposited thereon by a DC or RF plasma. Here, various chemical bonds can be achieved in accordance with the type of reaction gas, the DC current, voltage, RF power and deposition time, and therefore it is possible, as desired, to obtain a change in surface mechanical strength, adhesion, adsorption, hydrophilicity and hydrophobicity according to the present invention. In addition, by using such process, it is possible to produce the materials on the surface of the substrate without affecting any property of the substrate.

It will be apparent to those skilled in the art that various modifications and variations can be made in the plasma polymerization on the surface of the material of the present invention without departing from the scope of the invention. Thus, it is intended that the present invention cover modifications and variations of this invention provided they come within the scope of the appended claims and their equivalents.

## Claims

1. A method for surface processing by plasma polymerization of a surface of a metal or of an insulating material by using a DC discharge plasma, comprising the steps of:
(a) positioning an anode electrode and a cathode electrode in a chamber;
(b) maintaining a pressure in the chamber at a predetermined vacuum level;
(c) blowing an unsaturated aliphatic hydrocarbon monomer gas or a fluorine-containing monomer gas at a predetermined pressure and a non-polymerizable gas at a predetermined pressure into the chamber; and
(d) applying a voltage to the electrodes in order to obtain a DC discharge, whereby to obtain a plasma consisting of positive and negative ions and radicals generated from the unsaturated aliphatic hydrocarbon monomer gas or the fluorine containing monomer gas and the non-polymerizable gas, and then forming a polymer with hydrophilicity or hydrophobicity on a substrate to be coated by plasma deposition; **characterised in that** the substrate to be coated is positioned at the anode.

2. The method for surface processing by plasma polymerization according to claim 1, wherein the polymer obtained in the step (d) is surface-processed by a plasma of at least one non-polymerizable gas selected from a group consisting of O₂, N₂, CO₂, CO, H₂O and NH₃ gas in order to improve the hydrophlicity of the polymer.

3. The method for surface processing by plasma polymerization according to claim 2, wherein the nonpolymerizable gas is used with an inert gas.

4. The method for surface processing by plasma polymerization according to claim 1, wherein in the step (d), the polymerization process by the plasma is performed for 1 sec- 2min.

5. The method for surface processing by plasma polymerization according to claim 4, wherein in the step (d), the polymerization process by the plasma is performed for 5sec- 60sec.

6. The method for surface processing by plasma polymerization according to claim 1, wherein the ratio of the unsaturated aliphatic hydrocarbon monomer gas and the non-polymerizable gas is varied whereby to vary the properties of the polymer.

7. The method for surface processing by plasma polymerization according to claim 1, wherein the ratio of the fluorine-containing monomer gas and the non-polymerizable gas is varied whereby to vary the properties of the polymer.

8. The method for surface processing by plasma polymerization according to claim 7, wherein the fluorine-containing monomer gas comprises a monomer gas consisting of C, H and F such as C₂H₂F₂, C₂HF₃ and containing at least one carbon double bond.

9. The method for surface processing by plasma polymerization according to claim 1, wherein the non-polymerizable gas is 10-90% of the whole gas mixture.

10. The method for surface processing by plasma polymerization according to claim 1, wherein the polymer is annealed at a temperature of 100 - 400°C in the ambient atmosphere for 1 - 60min.

11. A method for surface processing by plasma polymerization of a surface of a materials including a metal, a ceramic or a polymer by using an RF discharge plasma, comprising the steps of:
(a) positioning an anode electrode and a cathode electrode which is substantial of metal in a chamber;
(b) maintaining a pressure in the chamber at a predetermined vacuum level;
(c) blowing an unsaturated aliphatic hydrocarbon monomer gas or a fluorine-containing monomer gas at a predetermined pressure and a non-polymerizable gas at a predetermined pressure into the chamber; and
(d) applying a voltage to the electrodes in order to obtain an RF discharge, whereby to obtain a plasma consisting of positive and negative ions and radicals generated from the unsaturated aliphatic hydrocarbon monomer gas or the fluorine containing monomer gas and the non-polymerizable gas, and then forming a polymer with hydrophilicity or hydrophobicity on a substrate to be coated by plasma deposition; **characterised in that** the substrate to be coated is positioned at the anode.

12. The method for surface processing by plasma polymerization according to claim 11, wherein properties of the polymer are determined by the ratio of the unsaturated aliphatic hydrocarbon monomer gas and the non-polymerizable gas.

13. The method for surface processing by plasma polymerization according to claim 11, wherein properties of the polymer are determined by the ratio of the fluorine-containing monomer gas and the non-polymerizable gas.

14. The method for surface processing by plasma polymerization according to claim 13, wherein the fluorine-containing monomer gas comprises a monomer gas consisting of C, H and F such as C₂H₂F₂, C₂HF₃ and containing at least one double bonding of carbon.

15. The method for surface processing by plasma polymerization according to claim 11, wherein the polymer is annealed at a temperature of 100 - 400°C in the ambient atmosphere for 1 - 60 min.

## Patentansprüche

1. Verfahren zur Oberflächenbearbeitung durch Plasma-Polymerisation von einer Oberfläche eines Metalls oder eines Isolierstoffes unter Verwendung von einem DC-Entladungsplasma, umfassend die folgenden Schritte:
(a) Einlegen einer Anodenelektrode und einer Kathodenelektrode in eine Kammer;
(b) Halten eines Drucks in der Kammer bei einem vorgegebenen Vakuumpegel;
(c) Einblasen eines ungesättigten aliphatischen Kohlenwasserstoff-enthaltenden monomeren Gases oder eines Fluor-enthaltenden monomeren Gases bei einem vorgegebenen Druck und eines nicht-polymerisierbaren Gases bei einem vorgegebenen Druck in die Kammer; und
(d) Anlegen einer Spannung zu den Elektroden, um 'eine DC-Entladung zu erhalten, wobei ein Plasma bestehend aus positiven und negativen Ionen und Resten, die aus dem ungesättigten aliphatischen Kohlenwasserstoffenthaltenden monomeren Gas oder dem Fluor-enthaltenden monomeren Gas und dem nicht-polymerisierbaren Gas erzeugt werden, erhält wird, wobei dann ein Polymer mit hydrophilen und hydrophoben Merkmalen auf dem durch Plasma-Deposition zu überziehenden Substrat gebildet wird; **dadurch gekennzeichnet, daß** das zu überziehende Substrat an der Anode liegt.

2. Verfahren zur Oberflächenbearbeitung durch Plasma-Polymerisation nach Anspruch 1, wobei das im Schritt (d) erhaltene Polymer durch ein Plasma mindestens eines nicht-polymerisierbaren Gases oberflächenbehandelt wird, ausgewählt aus der Gruppe umfassend gasförmige O₂, N₂, CO₂, H₂O und NH₃, um den hydrophilen Charakter des Polymers zu verbessern.

3. Verfahren zur Oberflächenbearbeitung durch Plasma-Polymerisation nach Anspruch 2, wobei das nichtpolymerisierbare Gas mit einem Inertgas verwendet wird.

4. Verfahren zur Oberflächenbearbeitung durch Plasma-Polymerisation nach Anspruch 1, wobei im Schritt (d) das Polymerisationsverfahren durch das Plasma für 1 Sek.-2 Min. durchgeführt wird.

5. Verfahren zur Oberflächenbearbeitung durch Plasma-Polymerisation nach Anspruch 4, wobei im Schritt (d) das Polymerisationsverfahren durch das Plasma für 5 Sek.-60 Sek. durchgeführt wird.

6. Verfahren zur Oberflächenbearbeitung durch Plasma-Polymerisation nach Anspruch 1, wobei das Verhältnis des ungesättigten aliphatischen Kohlenwasserstoffenthaltenden monomeren Gases zum nicht-polymerisierbaren Gas geändert wird, um die Eigenschaften des Polymers zu verändern.

7. Verfahren zur Oberflächenbearbeitung durch Plasma-Polymerisation nach Anspruch 1, wobei das Verhältnis des Fluor-enthaltenden monomeren Gases zum nicht-polymerisierbaren Gas geändert wird, um die Eigenschaften des Polymers zu verändern.

8. Verfahren zur Oberflächenbearbeitung durch Plasma-Polymerisation nach Anspruch 7, wobei das Fluorenthaltende monomere Gas ein monomeres Gas umfasst, das aus C, H und F besteht, wie C₂H₂F₂, C₂HF₃, und mindestens eine Kohlenstoff-Doppelbindung enthält.

9. Verfahren zur Oberflächenbearbeitung durch Plasma-Polymerisation nach Anspruch 1, wobei das nichtpolymerisierbare Gas 10-90% der gesamten Gasmischung ist.

10. Verfahren zur Oberflächenbearbeitung durch Plasma-Polymerisation nach Anspruch 1, wobei das Polymer bei einer Temperatur von 100-400°C in der Umgebungsatmosphäre für 1-60 Min. geglüht wird.

11. Verfahren zur Oberflächenbearbeitung durch Plasma-Polymerisation von einer Oberfläche eines Materials umfassend eines Metalls, eines keramischen Stoffes oder eines Polymers unter Verwendung von einem RF-Entladungsplasma, umfassend die folgenden Schritte:
(a) Einlegen einer Anodenelektrode und einer wesentlich metallischen Kathodenelektrode in eine Kammer;
(b) Halten eines Drucks in der Kammer bei einem vorgegebenen Vakuumpegel;
(c) Einblasen eines ungesättigten aliphatischen Kohlenwasserstoff-enthaltenden monomeren Gases oder eines Fluor-enthaltenden monomeren Gases bei einem vorgegebenen Druck und eines nicht-polymerisierbaren Gases bei einem vorgegebenen Druck in die Kammer; und
(d) Anlegen einer Spannung zu den Elektroden, um eine RF-Entladung zu erhalten, wobei ein Plasma bestehend aus positiven und negativen Ionen und Resten, die aus dem ungesättigten aliphatischen Kohlenwasserstoffenthaltenden monomeren Gas oder dem Fluor-enthaltenden monomeren Gas und dem nicht-polymerisierbaren Gas erzeugt werden, erhält wird, wobei dann ein Polymer mit hydrophilen und hydrophoben Merkmalen auf dem durch Plasma-Deposition zu überziehenden Substrat gebildet wird; **dadurch gekennzeichnet, daß** das zu überziehende Substrat an der Anode liegt.

12. Verfahren zur Oberflächenbearbeitung durch Plasma-Polymerisation nach Anspruch 11, wobei die Polymereigenschaften durch das Verhältnis des ungesättigten Kohlenwasserstoff-enthaltenden monomeren Gases zum nicht-polymerisierbaren Gas bestimmt werden.

13. Verfahren zur Oberflächenbearbeitung durch Plasma-Polymerisation nach Anspruch 11, wobei die Polymereigenschaften durch das Verhältnis des' Fluor-enthaltenden monomeren Gases zum nicht-polymerisierbaren Gas bestimmt werden.

14. Verfahren zur Oberflächenbearbeitung durch Plasma-Polymerisation nach Anspruch 13, wobei das Fluorenthaltende monomere Gas ein monomeres Gas umfasst, das aus C, H und F besteht, wie C₂H₂F₂, C₂HF₃, und mindestens eine Kohlenstoff-Doppelbindung enthält.

15. Verfahren zur Oberflächenbearbeitung durch Plasma-Polymerisation nach Anspruch 11, wobei das Polymer bei einer Temperatur von 100-400°C in der Umgebungsatmosphäre für 1-60 Min. geglüht wird.

## Revendications

1. Méthode pour le traitement de surface par polymérisation par plasma sur une surface d'un métal ou d'une matière isolante en utilisant un plasma à décharge à courant continu, comprenant les étapes de:
(a) mettre en place une électrode anodique et une électrode cathodique dans une chambre;
(b) maintenir une pression dans la chambre à un niveau de vide prédéterminé;
(c) souffler un gaz monomère d'hydrocarbure aliphatique non saturé ou un gaz monomère contenant du fluor à une pression prédéterminée et un gaz non-polymérisable à une pression prédéterminée dans la chambre; et
(d) appliquer une tension aux électrodes dans le but d'obtenir une décharge à courant continu, obtenant ainsi un plasma se composant de ions positifs et négatifs et de radicaux engendrés à partir du gaz monomère d'hydrocarbure aliphatique non saturé ou du gaz monomère contenant du fluor et du gaz non-polymérisable, et former ensuite un polymère ayant un caractère hydrophile ou un caractère hydrophobe sur un substrat à revêtir par dépôt de plasma; **caractérisée en ce que** le substrat à revêtir est positionné à l'anode.

2. Méthode pour le traitement de surface par polymérisation par plasma selon la revendication 1, dans laquelle le polymère obtenu à l'étape (d) est traité en surface par un plasma d'au moins un gaz non-polymérisable choisi parmi un groupe se composant de O₂, N₂, CO₂, CO, H₂O et NH₃ gazeux dans le but d'améliorer le caractère hydrophile du polymère.

3. Méthode pour le traitement de surface par polymérisation par plasma selon la revendication 2, dans laquelle le gaz non-polymérisable est employé avec un gaz inerte.

4. Méthode pour le traitement de surface par . polymérisation par plasma selon la revendication 1, dans laquelle à l'étape (d), le procédé de polymérisation par plasma est exécuté pendant 1 seconde-2 minutes.

5. Méthode pour le traitement de surface par polymérisation par plasma selon la revendication 4, dans laquelle à l'étape (d), le procédé de polymérisation par plasma est exécuté pendant 5 secondes-60 secondes.

6. Méthode pour le traitement de surface par polymérisation par plasma selon la revendication 1, dans laquelle le rapport du gaz monomère d'hydrocarbure aliphatique non saturé et du gaz non-polymérisable est varié de manière à varier les propriétés du polymère.

7. Méthode pour le traitement de surface par polymérisation par plasma selon la revendication 1 ou 2, dans laquelle le rapport du gaz monomère contenant du fluor et du gaz non-polymérisable est varié de manière à varier les propriétés du polymère.

8. Méthode pour le traitement de surface par polymérisation par plasma selon la revendication 7, dans laquelle le gaz monomère contenant du fluor comporte un gaz monomère se composant de C, H et F comme par exemple C₂H₂F₂, C₂HF₃ et contenant au moins une liaison double de carbone.

9. Méthode pour le traitement de surface par polymérisation par plasma selon la revendication 1, dans laquelle le gaz non polymérisable est 10-90% de tout le mélange de gaz.

10. Méthode pour le traitement de surface par polymérisation par plasma selon la revendication 1, dans laquelle le polymère est recuit à une température de 100-400°C en atmosphère ambiante pendant 1-60 minutes.

11. Méthode pour le traitement de surface par polymérisation par plasma sur une surface de matières comprenant un métal, une céramique ou un polymère en utilisant un plasma à décharge haute fréquence, comprenant les étapes de:
(a) mettre en place une électrode anodique et une électrode cathodique qui est essentiellement de métal dans une chambre;
(b) maintenir une pression dans la chambre à un niveau de vide prédéterminé;
(c) souffler un gaz monomère d'hydrocarbure aliphatique non saturé ou un gaz monomère contenant du fluor à une pression prédéterminée et un gaz non-polymérisable à une pression prédéterminée dans la chambre; èt
(d) appliquer une tension aux électrodes dans le but d'obtenir une décharge haute fréquence, obtenant ainsi un plasma se composant de ions positifs et négatifs et de radicaux engendrés à partir du gaz monomère d'hydrocarbure aliphatique non saturé ou du gaz monomère contenant du fluor et du gaz non-polymérisable, et former ensuite un polymère ayant un caractère hydrophile ou un caractère hydrophobe sur un substrat à revêtir par dépôt de plasma; **caractérisée en ce que** le substrat à revêtir est positionné à l'anode.

12. Méthode pour le traitement de surface par polymérisation par plasma selon la revendication 11, dans laquelle les propriétés du polymère sont déterminées par le rapport entre le gaz monomère d'hydrocarbure non saturé et le gaz non polymérisable.

13. Méthode pour le traitement de surface par polymérisation par plasma selon la revendication 11, dans laquelle les propriétés du polymère sont déterminées par le rapport du gaz monomère contenant du fluor et du gaz non-polymérisable.

14. Méthode pour le traitement de surface par polymérisation par plasma selon la revendication 13, dans laquelle le gaz monomère contenant du fluor comporte un gaz monomère se composant de C, H et F comme par exemple C₂H₂F₂, C₂HF₃ et contenant au moins une liaison double de carbone.

15. Méthode pour le traitement de surface par polymérisation par plasma selon la revendication 11, dans laquelle le polymère est recuit à une température de 100-400°C en atmosphère ambiante pendant 1 - 60 minutes.
